(19) Europäisches Patentamt
European Patent Office
Office européen des brevets

(11) **EP 2 913 786 B1**

(12) **FASCICULE DE BREVET EUROPEEN**

(45) Date de publication et mention de la délivrance du brevet:
**16.11.2016 Bulletin 2016/46**

(51) Int Cl.:
*G06Q 10/04* (2012.01)     *G06Q 50/06* (2012.01)
*H02J 13/00* (2006.01)     *G01D 4/00* (2006.01)
*G01R 21/133* (2006.01)

(21) Numéro de dépôt: **15156599.1**

(22) Date de dépôt: **25.02.2015**

(54) **Estimation de la consommation électrique d'un équipement donné parmi un ensemble d'équipements électriques**

Abschätzung des Stromverbrauchs eines bestimmten Geräts unter mehreren elektrischen Geräten

Estimation of the power consumption of a specific device among a set of electrical devices

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **26.02.2014 FR 1451531**

(43) Date de publication de la demande:
**02.09.2015 Bulletin 2015/36**

(73) Titulaire: **Electricité de France**
**75008 Paris (FR)**

(72) Inventeurs:
• **Bozzi, Laurent**
  **94420 Le Plessis-Trevise (FR)**
• **Yard, Grégory**
  **92220 Bagneux (FR)**

(74) Mandataire: **Cabinet Plasseraud**
**66, rue de la Chaussée d'Antin**
**75440 Paris Cedex 09 (FR)**

(56) Documents cités:
• **MABROUKA EL GUEDRI: "Caractérisation aveugle de la courbe de charge électrique: Détection, classification et estimation des usages dans les secteurs résidentiel et tertiaire",** THESE DE DOCTORAT, SP?CIALIT? : PHYSIQUE, ?COLE DOCTORALE ? SCIENCES ET TECHNOLOGIES DE L?INFORMATION,DES T?L?COMMUNICATIONS ET DES SYST?MES ?, FR , 9 novembre 2009 (2009-11-09), pages 1-232, XP002680597, Extrait de l'Internet: URL:http://innovation.edf.com/fichiers/fck editor/Commun/Innovation/theses/TheseElGue dri.pdf [extrait le 2012-07-20]
• **KAUSTAV BASU ET AL:"Load identification from power recordings at meter panel in residential households",** ELECTRICAL MACHINES (ICEM), 2012 XXTH INTERNATIONAL CONFERENCE ON, IEEE, 2 septembre 2012 (2012-09-02), pages 2098-2104, XP032465003, DOI: 10.1109/ICELMACH.2012.6350172 ISBN: 978-1-4673-0143-5
• **BASU KAUSTAV ET AL: "Residential appliance identification and future usage prediction from smart meter",** IECON 2013 - 39TH ANNUAL CONFERENCE OF THE IEEE INDUSTRIAL ELECTRONICS SOCIETY, IEEE, 10 novembre 2013 (2013-11-10), pages 4994-4999, XP032539405, ISSN: 1553-572X, DOI: 10.1109/IECON.2013.6699944 [extrait le 2013-12-30]

• LINDA FARINACCIO ET AL: "Using a pattern recognition approach to disaggregate the total electricity consumption in a house into the major end-uses", ENERGY AND BUILDINGS, vol. 30, no. 3, 1 août 1999 (1999-08-01), pages 245-259, XP055119182, ISSN: 0378-7788, DOI: 10.1016/S0378-7788(99)00007-9

## Description

La présente invention concerne l'estimation de la consommation électrique d'un équipement parmi un ensemble d'équipements, en particulier, mais non exclusivement, l'estimation de la consommation d'un chauffe-eau (aussi appelé « ballon d'Eau Chaude Sanitaire» ou « ballon d'ECS » par la suite) d'un foyer, à partir d'une courbe de charge correspondant à la consommation électrique totale du foyer.

Elle trouve des applications dans l'optimisation de la courbe de charge totale par déplacement de périodes d'enclenchement du ballon d'ECS, mais également dans la fourniture de mesures détaillées au client de ses consommations électriques.

Dans le cadre du développement de réseaux de distribution d'électricité intelligents (appelés « SmartGrids ») permettant d'optimiser la production, la distribution et la consommation, et de l'utilisation croissante d'Energies Renouvelables (EnR), la production générale d'électricité tend à se décentraliser ce qui impose des contraintes fortes pour maintenir un équilibre entre l'offre et la demande d'électricité.

Parmi les EnR, la production photovoltaïque est particulière puisqu'elle intervient de façon pratiquement certaine autour des heures méridiennes. Cependant, un tel surplus d'énergie ne correspond pas aux heures de pointe de consommation électrique, généralement situées entre 7h et 9h le matin, et 18h et 20h le soir. Il y a donc un besoin d' « absorber » une telle énergie.

Or, dans la consommation résidentielle, l'un des usages offrant le plus de flexibilité est le chauffage de l'Eau Chaude Sanitaire (ECS) dans des ballons d'eau chaude. En effet, de tels ballons, équipant une grande partie des foyers, permettent un « stockage » d'électricité, dans la mesure où leur consommation électrique, nécessaire pour chauffer un volume d'eau, est bien antérieure au soutirage de l'eau chaude pour les besoins du foyer.

Il est ainsi possible de décaler la consommation électrique d'ECS, qui a lieu généralement pendant des heures creuses durant la nuit, vers des heures creuses méridiennes, et ce afin d' « absorber » le surplus de production photovoltaïque pendant ces heures creuses méridiennes. On appelle « heures creuses » une période durant laquelle la consommation électrique globale, pour un grand ensemble de foyers, est relativement faible, et durant laquelle le coût associé aux consommations électriques est réduit. De telles périodes ne sont pas fixes (elles dépendent notamment des saisons) et dépendent des entreprises de production et de distribution d'énergie.

Afin de pouvoir déplacer les périodes d'enclenchement des ballons d'ECS de manière optimisée, il convient de prévoir la consommation électrique d'ECS du jour pour le lendemain, en particulier à partir de modèles de prévision se basant sur un historique de consommation électrique d'ECS pour les jours passés.

Il est ainsi nécessaire de connaître la consommation électrique d'ECS pour chaque foyer. En outre, une telle connaissance peut permettre la fourniture d'une facture détaillée (par usage) au client.

Des solutions existantes permettent de différencier une courbe de charge totale de consommation électrique par usages.

Par exemple, l'algorithme « Beluso » proposé par la société Fludia propose de décomposer une courbe de charge totale individuelle (pour un foyer) par usage. A cet effet, il requiert la connaissance de la courbe de charge totale, sur une période donnée, mais il nécessite également des informations complémentaires sur le logement du foyer. Par exemple, un questionnaire est à remplir par le foyer de pouvoir disposer d'informations relatives à la surface du logement ainsi qu'aux principaux appareils électriques.

Une autre solution a été proposée dans la thèse de Mabrouka EL GUEDRI, soutenue le 9 novembre 2009 et intitulée « Caractérisation aveugle de la courbe de charge électrique : Détection, classification et estimation des usages dans les secteurs résidentiel et tertiaire ». La méthode retenue dans cette thèse consiste à extraire la courbe de consommation électrique d'ECS d'une courbe de charge totale, la courbe de charge totale étant basée sur un relevé des consommations toutes les secondes, ce qui est coûteux à mettre en oeuvre en pratique.

D'autres solutions connues reposent sur la technologie NILM ou NIALM pour *« Non Intrusive Appliance Load Monitoring »,* qui consiste en un processus d'analyse des variations de la tension et de la charge dans un logement afin d'en déduire quels appareils sont utilisés ainsi que leurs consommations respectives. Toutefois, un tel processus requiert à nouveau une relève à une fréquence élevée, d'un ordre allant du Hertz au kiloHertz (kHz). Comme précédemment évoqué, des telles fréquences impliquent des coûts élevés.

Ainsi, il existe un besoin d'estimer la consommation électrique d'un équipement parmi un ensemble d'équipements électriques, sans connaissance préalable des équipements et sans nécessiter une fréquence élevée pour la relève de la charge globale des équipements.

La présente invention vient améliorer la situation.

Un premier aspect de l'invention concerne un procédé d'estimation de la consommation électrique d'un équipement électrique donné parmi un ensemble d'équipements électriques, comprenant les étapes suivantes mises en oeuvre par un dispositif d'estimation:

- réception d'une courbe de charge représentative de la consommation électrique de l'ensemble d'équipements électriques à des instants donnés, sur une période donnée ;

- détermination d'une enveloppe basse de la courbe de charge ;
- estimation d'une courbe de la puissance électrique consommée par l'équipement électrique donné sur la période donnée, par soustraction de l'enveloppe basse déterminée à la courbe de charge.

La prise en compte de l'enveloppe basse de la courbe de charge permet d'utiliser une courbe de charge ayant un pas de l'ordre de la minute au moins, ce qui réduit le coût associé à l'obtention de la courbe de charge comparativement aux techniques de l'art antérieur. En outre, le procédé selon l'invention ne requiert aucune connaissance de l'ensemble des équipements, et le client n'a alors pas besoin de remplir au préalable un formulaire déclaratif. L'estimation de la courbe de puissance consommée par l'équipement électrique peut permettre différentes applications :

- fourniture d'une facture détaillée au client, par usage ;
- prédiction d'une durée de fonctionnement de l'équipement pour des périodes futures, notamment en vue d'optimiser la production d'énergie ou de déplacer les périodes de fonctionnement de l'équipement donné afin de synchroniser l'offre et la demande en énergie électrique.

Selon un mode de réalisation de l'invention, les instants donnés peuvent être espacés à intervalles réguliers, les intervalles réguliers étant supérieurs à une minute.

Par exemple, un pas de 30 minutes peut être prévu, ce qui réduit considérablement les coûts liés à l'obtention de la courbe de charge.

Dans un mode de réalisation, l'équipement électrique donné peut être un ballon d'eau chaude sanitaire et la période donnée peut comprendre au moins une période d'heures creuses, et l'estimation de la courbe de la puissance électrique consommée par l'équipement électrique peut être restreinte à la période d'heures creuses.

La présente invention trouve ainsi avantageusement une application dans le domaine de l'eau chaude sanitaire, dans lequel de l'énergie peut être stockée. En effet, le chauffage de ballons d'ECS est un usage dont le fonctionnement peut être affecté de manière relativement souple à une tranche horaire donnée. Ainsi, en prévoyant les durées de fonctionnement de ballon d'ECS, il est possible de déplacer le fonctionnement des ballons d'ECS dans des tranches horaires durant lesquelles un surplus d'énergie est produit.

Selon une réalisation de l'invention, le procédé peut comprendre en outre une étape d'estimation de la puissance maximale consommée par l'équipement donné, et une étape d'application d'une première correction à la courbe estimée, en vue d'obtenir une première courbe corrigée, la première correction consistant à limiter la puissance consommée par l'appareil électrique à des valeurs inférieures à la puissance maximale, sur la période donnée.

Une telle réalisation permet d'améliorer la précision associée à l'estimation de la puissance électrique consommée par l'équipement donné.

Selon un mode de réalisation, le volume du ballon d'eau chaude sanitaire peut être connu et la puissance maximale consommée peut être estimée à partir du volume du ballon d'eau chaude sanitaire.

Ainsi, la puissance maximale peut être déduite de manière simple.

En variante, une courbe de charge continue représentant la consommation électrique de l'ensemble des équipements pour une période antérieure à la période donnée est stockée, la période antérieure étant continue et comprenant au moins des périodes d'heures creuses et d'heures pleines, et l'étape d'estimation de la puissance maximale consommée par l'équipement électrique peut comprendre :

- déterminer, pour chaque période d'heures creuses antérieure, la différence entre la valeur de la courbe de charge au premier instant ou au deuxième instant de la période d'heures creuses et la valeur de la courbe de charge à l'instant précédant directement le premier instant ;
- estimer, à partir des différences déterminées, la puissance maximale consommée par l'équipement électrique.

Selon cette variante, la puissance maximale peut être obtenue sans connaissance préalable sur l'équipement donné.

Selon un mode de réalisation de l'invention, sur réception de la courbe de charge, le procédé peut comprendre l'application d'une décomposition en ondelettes afin d'obtenir une courbe de charge débruitée, et l'enveloppe basse peut être déterminée à partir de la courbe de charge débruitée, et la courbe de puissance électrique consommée par l'équipement donné peut être estimée par soustraction de l'enveloppe basse à la courbe de charge débruitée, sur la période donnée.

Ce mode de réalisation permet de s'affranchir d'usages faiblement consommateurs en puissance électrique lors de l'estimation de la puissance électrique consommée par l'équipement électrique donné.

Selon une réalisation de l'invention, la courbe de charge peut être en outre reçue pour des périodes précédant et suivant la période donnée et l'étape de détermination de l'enveloppe basse de la courbe de charge peut comprendre les étapes suivantes, pour chaque instant de la période donnée :

- déterminer la valeur minimale entre les valeurs de la courbe de charge respectives pour les n instants précédant l'instant donné, pour l'instant donné et pour les n instants suivant l'instant donné, n étant entier supérieur ou égal à un ;
- attribuer à l'instant la valeur minimale déterminée.

Les valeurs minimales peuvent ensuite être reliées pour obtenir l'enveloppe basse de la courbe de charge.

En complément, un taux de variation $T[P(t)]$ de la courbe de charge à un instant t donné de la période donné est déterminé de la manière suivante :

$$T[P(t)] = [P(t) - P(t-1) / P(t-1) \; ;$$

$P(t)$ représentant la puissance consommée par l'ensemble d'équipements à l'instant donné t et $P(t-1)$ représentant la puissance consommée par l'ensemble d'équipements à l'instant t-1 précédant directement l'instant donné t.

Le procédé peut comprendre en outre une étape d'application d'une deuxième correction à la courbe estimée, notée $ECS_1$, en vue d'obtenir une deuxième courbe corrigée, notée $ECS_2$, $t_0$ étant l'instant de début d'une période d'heures creuses de la période donnée, une variable $ECS\_plateau$ étant initialisée à la valeur de la courbe estimée $ECS_1$ à l'instant $t_0$, la deuxième courbe corrigée étant obtenue de la manière suivante, pour tous les instants t suivant l'instant $t_0$ de ladite période d'heures creuses:

- si $t < t_0 + th_1$, et si $|T[P(t)]| < th_2$, alors $ECS_2(t) = Max(ECS\_plateau*(1 + T[P(t)] \; ; \; ECS_1(t))$
- sinon,

  o si $t \geq t_0 + th_1$ et $|T[P(t)]| < th_3$, alors $ECS_2(t) = ECS_1(t)$ et $ECS\_plateau = ECS_1(t)$;
  o sinon,

    ■ si $T[P(t)] < -th_4$ ou $T[P(t)] > th_2$ alors $ECS_2(t) = ECS_1(t)$ et $ECS\_plateau$ est mis à jour à la valeur $ECS_1(t)$ pour les instants suivant l'instant t dans la période d'heures creuses;
    ■ sinon $ECS_2(t) = ECS_1(t)$ ;

  dans lequel $Max(A,B)$ désigne la valeur maximale entre A et B ;
  dans lequel $th_1$ est un seuil prédéterminé exprimé en heures ;
  dans lequel $th_2$, $th_3$ et $th_4$ sont des seuils prédéterminés exprimés en pourcentages, $th_3$ étant inférieur à $th_2$.

L'application de la deuxième correction permet d'améliorer considérablement l'estimation de la puissance consommée par l'équipement donné.

En complément, la puissance maximale consommée par l'équipement donné est notée Pmax, le procédé peut comprendre en outre une étape d'application d'une troisième correction à la deuxième courbe corrigée $ECS_2$, en vue d'obtenir une troisième courbe corrigée, notée $ECS_3$ et la troisième courbe corrigée peut être obtenue de la manière suivante, pour tous les instants t antérieurs à l'instant $t_0 + th_1$: si $ECS_2(t) < \dfrac{P\max}{3}$, si $ECS_2(t-1) > \dfrac{2 * P\max}{3}$ et si $ECS_2(t+1) > \dfrac{2 * P\max}{3}$ alors $ECS_3(t) = \dfrac{ECS_2(t-1) + ECS_2(t+1)}{2}$ ; sinon, $ECS_3(t) = ECS_2(t)$.

Le troisième correctif améliore en outre la précision du procédé et permet d'approcher la courbe réelle de la consommation de l'équipement donné.

En complément ou en variante, l'équipement donné peut fonctionner par périodes d'enclenchement comprises dans une période d'heures creuses de la période donnée, dans lequel la puissance électrique est consommée par l'équipement électrique donné uniquement durant les périodes d'enclenchement, la période d'heures creuses comprenant au moins une première période d'enclenchement et une deuxième période d'enclenchement.

Le procédé peut comprendre en outre l'application d'une quatrième correction à la deuxième courbe corrigée $ECS_2$, en vue d'obtenir une quatrième courbe corrigée, notée $ECS_4$, la quatrième correction comprenant :

- détermination d'un instant $t_1$ de démarcation entre la première période d'enclenchement et la deuxième période d'enclenchement;

- détermination d'un plafond $th_{second}$ de second enclenchement, étant exprimé en pourcentages ;

et la quatrième courbe corrigée $ECS_4$ peut être obtenue de la manière suivante :

- pour $t \in [t_0;t_1]$, $ECS_4(t) = ECS_2(t)$ ;

- pour $t \in \, ]t_1;t_f]$, $ECS_4(t) = Min\left\{\underset{t<t_1}{Max}\left\{ECS_2(t)\right\} \times th_{second}; ECS_2(t)\right\}$

Min(A ;B) désignant le minimum entre A et B ;
$t_f$ étant un instant de fin de la période donnée.

En variante, la quatrième correction peut être appliquée à la troisième courbe corrigée $ECS_3$.

La quatrième correction améliore en outre la précision de l'estimation de la puissance électrique consommée par l'équipement donné, en limitant les estimations des appels en puissance de l'appareil électrique dans les deuxièmes périodes d'enclenchement.

Selon un mode de réalisation de l'invention, le procédé peut comprendre en outre la prévision d'une durée de fonctionnement de l'équipement électrique donnée pour une période postérieure à la période donnée, en fonction de la courbe de la puissance électrique consommée par l'équipement électrique sur la période donnée.

Un deuxième aspect de l'invention concerne un produit programme d'ordinateur comprenant des instructions de code de programme enregistrées sur un support lisible par un ordinateur, pour l'exécution des étapes du procédé selon le premier aspect de l'invention.

Un troisième aspect de l'invention concerne un dispositif d'estimation de la consommation électrique d'un équipement électrique donné parmi un ensemble d'équipements électriques, comprenant :

- une unité de réception d'une courbe de charge représentative de la consommation électrique de l'ensemble d'équipements électriques à des instants donnés, sur une période donnée ;
- une unité de détermination d'une enveloppe basse de la courbe de charge ;
- une unité d'estimation d'une courbe de la puissance électrique consommée par l'équipement électrique sur la période donnée, par soustraction de l'enveloppe basse déterminée à la courbe de charge.

D'autres caractéristiques et avantages de l'invention apparaîtront à l'examen de la description détaillée ci-après, et des dessins annexés sur lesquels:

- la figure 1 présente un système selon un mode de réalisation de l'invention;
- la figure 2 est un diagramme illustrant l'évolution de la puissance globale consommée par un ensemble des équipements électriques, sur une période antérieure à une période donnée ;

- la figure 3 est une monotone de N valeurs de la puissance maximale appelée par un équipement donné ;
- la figure 4 est un diagramme illustrant une courbe de charge globale d'un ensemble d'équipements électriques, sur une période donnée ;
- la figure 5 est un diagramme illustrant une courbe de charge globale d'un ensemble d'équipements électriques ainsi que l'enveloppe basse de la courbe de charge restreinte, sur une période donnée ;
- la figure 6 est un diagramme illustrant une courbe de charge globale d'un ensemble d'équipements électriques ainsi que l'enveloppe basse de la courbe de charge restreinte à des périodes d'heures creuses, sur une période donnée ;
- la figure 7 est un diagramme illustrant une courbe de charge globale d'un ensemble d'équipements électriques, l'enveloppe basse de la courbe de charge, ainsi qu'une courbe estimée de la consommation électrique d'un équipement donné de l'ensemble d'équipements électriques, sur une période donnée ;
- la figure 8 est un diagramme illustrant une courbe de consommation réelle d'un équipement électrique donné ainsi qu'une courbe estimée de la consommation de l'équipement électrique, sur une période donnée ;
- la figure 9 est un diagramme illustrant une courbe de consommation réelle d'un équipement électrique donné, une courbe estimée de la consommation de l'équipement électrique ainsi qu'une première courbe corrigée de la consommation de l'équipement électrique, sur une période donnée ;
- la figure 10 est un diagramme illustrant une courbe de consommation réelle d'un équipement électrique donné, une courbe estimée de la consommation de l'équipement électrique ainsi qu'une deuxième courbe corrigée de la consommation de l'équipement électrique, sur une période donnée ;
- la figure 11 est un diagramme illustrant deux courbes de la consommation réelle d'un équipement donné, obtenues à partir de la relève de mesures espacées par deux pas différents, pour une période donnée ;

- la figure 12 est un diagramme illustrant une courbe de consommation réelle d'un équipement électrique donné, une courbe estimée de la consommation de l'équipement électrique ainsi qu'une quatrième courbe corrigée de la consommation de l'équipement électrique, sur une période donnée ;
- la figure 13 est un diagramme représentant les étapes du procédé selon un mode de réalisation de l'invention.

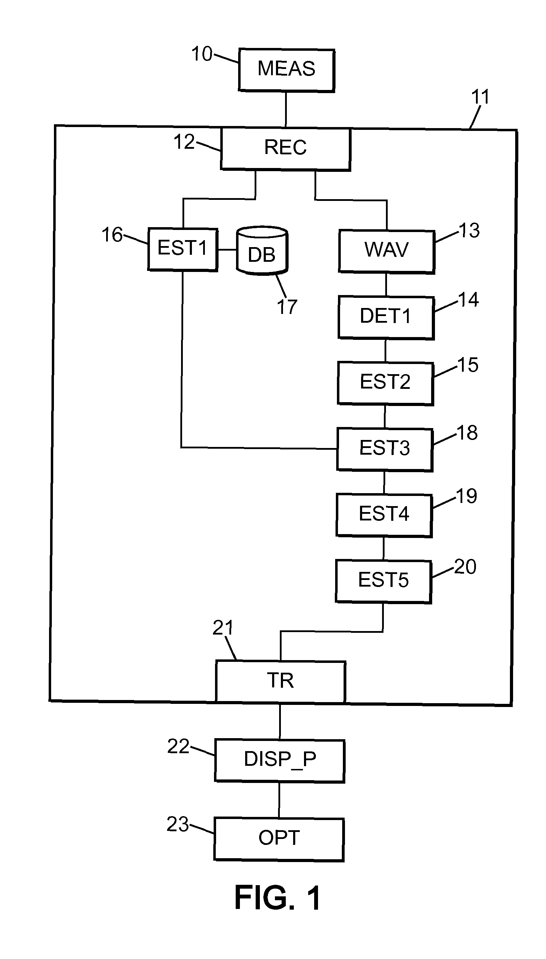

La figure 1 illustre un système selon un mode de réalisation de l'invention.

Le système comprend une unité de mesure de la consommation électrique d'un ensemble d'équipements électriques. A titre d'exemple, l'ensemble d'équipements peut correspondre aux équipements électriques d'un foyer, et comprend notamment un équipement électrique donné, dont la consommation électrique est estimée par le système selon l'invention. L'équipement électrique donné peut par exemple être un ballon d'ECS du foyer. Un tel ballon d'ECS fonctionne en « tout ou rien » par intermittences. On appelle « périodes d'enclenchement » les périodes durant lesquelles le ballon d'ECS consomme de la puissance électrique. De manière générale, en début des heures creuses, une puissance maximale est appelée par le ballon d'ECS pendant un temps donné, jusqu'à ce que l'eau contenue dans le ballon atteigne une température de consigne. Des relances peuvent être opérées ensuite, durant les heures creuses, si la température de l'eau dans le ballon baisse.

Les mesures peuvent être effectuées à des instants donnés, par exemple à des instants séparés par des intervalles réguliers dans le temps. Ces intervalles sont appelés « pas » dans la suite de la description. Selon l'invention, le pas utilisé est au moins de l'ordre de la minute, ce qui permet avantageusement de réduire les coûts liés à la mesure de la consommation électrique, comparativement aux techniques de l'art antérieur qui requièrent un pas d'un ordre égal ou inférieur à la seconde.

Dans la suite de la description, un pas de 30 minutes est utilisé préférentiellement. Toutefois, aucune restriction n'est attachée à la valeur du pas, et l'exemple du pas de 30 minutes est utilisé à titre illustratif.

Un tel dispositif de mesure peut par exemple être implémenté dans un boîtier électrique d'un foyer.

A partir des relèves successives durant une période donnée, l'unité de mesure 10 peut créer une courbe de charge représentative de la consommation électrique de l'ensemble d'équipements électriques. La courbe de charge ainsi créée peut être transmise à un dispositif d'estimation 11 selon un mode de réalisation de l'invention. De manière alternative, le dispositif de mesure 10 peut simplement envoyer périodiquement au dispositif d'estimation 11 une mesure ponctuelle de la puissance totale consommée, et la courbe de charge est alors créée par le dispositif d'estimation 11.

La période donnée peut par exemple correspondre à une journée ou à plusieurs journées. Elle peut également être restreinte aux périodes d'heures creuses uniquement. Ainsi, aucune restriction n'est attachée à la période donnée considérée. Le dispositif d'estimation 11 comprend une unité de réception 12 afin de recevoir la courbe de charge (ou en variante les mesures brutes de l'unité de mesure 10, auquel cas l'unité de réception peut en outre créer la courbe de charge).

Une première unité d'estimation 16 du dispositif d'estimation 11 est apte à estimer la puissance maximale, notée Pmax, pouvant être consommée (ou « appelée ») par le ballon d'ECS.

Selon un mode de réalisation, la valeur Pmax peut être estimée à partir du volume du ballon d'ECS.

La relation entre la puissance maximale du ballon et son volume est généralement connue. A titre d'exemple, les équivalences suivantes peuvent être considérées :

- un ballon de 100L équivaut à une puissance Pmax de 1200 Watts (W) ;
- un ballon de 150 L équivaut à une puissance Pmax de 1800 W ;
- un ballon de 200 L équivaut à une puissance Pmax de 2200 W ;
- un ballon de 300 L équivaut à une puissance Pmax de 3000 W.

Pour les autres volumes de ballons d'ECS, les valeurs suivantes peuvent être utilisées :

- 12 fois le volume en litres du ballon pour obtenir la puissance en Watts, pour des volumes inférieurs à 175 L ;
- 11 fois le volume en litres du ballon pour obtenir la puissance en Watts, pour des volumes compris entre 175 L et 250 L ;
- 10 fois le volume en litres du ballon pour obtenir la puissance en Watts, pour des volumes compris entre 250 L et 350 L ;
- 8 fois le volume en litres du ballon pour obtenir la puissance en Watts, pour des volumes supérieurs à 350 L.

Un tel mode de réalisation requiert toutefois la connaissance préalable du volume du ballon d'ECS.

Afin de pallier à cet inconvénient, l'invention prévoit un autre mode de réalisation pour déterminer la puissance Pmax.

Selon ce deuxième mode de réalisation, une courbe de charge globale présentant des mesures durant la période antérieure à la période donnée sont stockées dans une base de données 17 du dispositif d'estimation 11. La période antérieure est de préférence continue et comprend ainsi à la fois des périodes d'heures creuses et des périodes d'heures pleines.

Ce deuxième mode de réalisation repose sur le fait que, lors du passage en heures creuses, la ballon d'ECS s'enclenche et fonctionne à pleine puissance. Si aucun autre usage (autre appareil du foyer en fonctionnement) ne vient perturber la charge, la valeur Pmax est la différence entre la valeur de charge au premier instant (ou premier pas) de la période d'heures creuses, ou la valeur de charge au deuxième instant (ou deuxième pas) de la période d'heures creuses, et la valeur de la charge juste avant l'enclenchement des heures creuses (en période d'heures pleines).

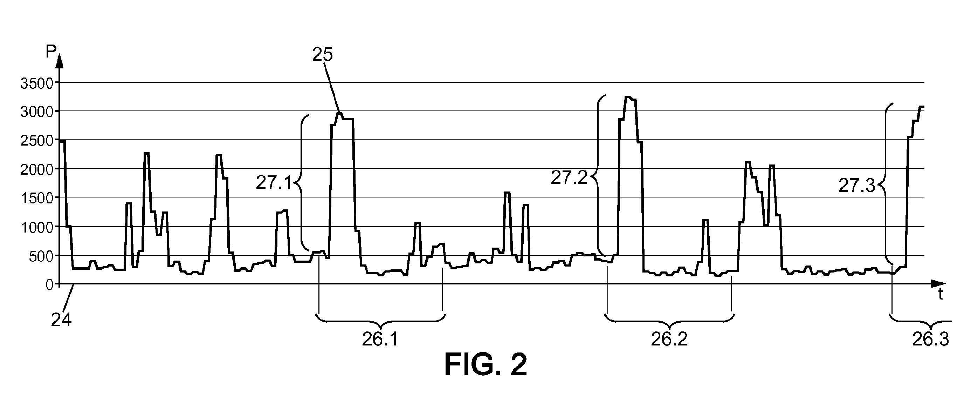

La Figure 2 est un diagramme 24 présentant la courbe de charge globale 25, comprenant trois périodes d'heures creuses référencées 26.1, 26.2 et 26.3. La courbe de charge globale 25 présente ainsi l'évolution de la puissance globale consommée par l'ensemble des équipements électriques du foyer, sur une période antérieure à la période donnée, avec un pas de trente minutes.

Comme représenté sur le diagramme 24, la courbe de charge globale 25 atteint des valeurs maximales au début des périodes d'heures creuses 26.1, 26.2 et 26.3, soit pendant les trente premières minutes de chaque période d'heures creuses, ou durant les trente minutes suivantes.

Les différences respectives entre ces valeurs maximales et les valeurs à l'instant précédant directement l'enclenchement des périodes d'heures creuses, sont référencées 27.1, 27.2 et 27.3. Il est possible d'obtenir la puissance Pmax en moyennant ces différences.

Un problème se pose toutefois lorsque d'autres usages que le chauffage du ballon d'ECS appellent de la puissance lors de l'enclenchement des périodes d'heures creuses (lave linge, lave vaisselle, par exemple).

La présente invention propose à cet effet d'utiliser une courbe appelée « monotone », représentant N valeurs de différences 27.1, 27.2, 27.3, pour un ensemble de N périodes d'heures creuses antérieures à la période donnée. Afin d'obtenir des résultats fiables, un nombre N supérieur à 100 peut être prévu. La monotone présente les valeurs des différences 27.1, 27.2, 27.3 dans un ordre décroissant, en fonction d'un index de chaque période parmi les N périodes d'heures creuses antérieures.

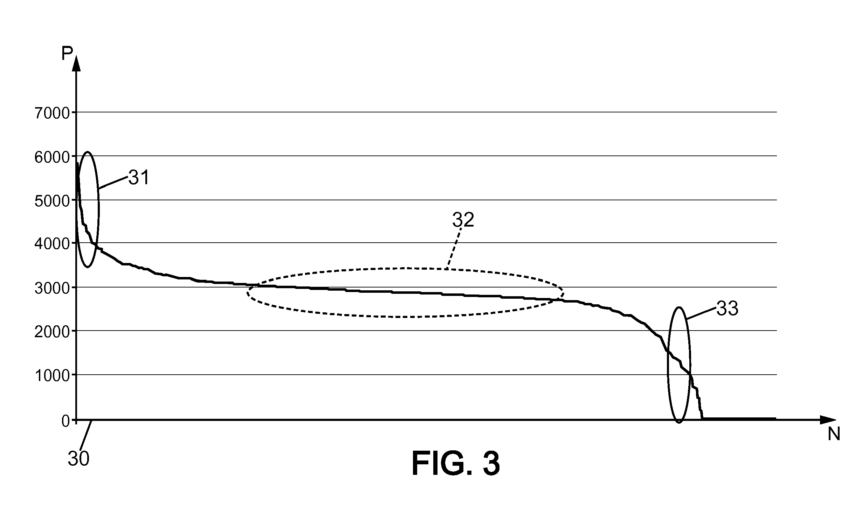

Une telle monotone est représentée sur le diagramme 30 de la Figure 3.

Les valeurs des différences sont maximales dans la zone 31. Elles sont obtenues dans des périodes d'heures creuses où l'enclenchement du ballon est accompagné de l'enclenchement d'un autre usage.

Les valeurs des différences sont minimales dans la zone 33. Elles sont obtenues pour des périodes d'heures creuses avec une utilisation partielle ou nulle du ballon d'ECS.

En revanche, dans la zone 32, les valeurs des différences correspondent à des périodes d'heures creuses durant lesquelles seul le ballon d'ECS a appelé une puissance maximale.

Un algorithme permet de détecter un tel plat (zone 32) dans la monotone. A cet effet, l'algorithme peut parcourir les N points consécutifs, et s'arrêter lorsque le ratio $P(k)/P(k-2)$ est proche de 1 (par exemple supérieur à 0,998) sur M points consécutifs, $P(k)$ étant la valeur de la différence obtenue pour la k-ième période d'heures creuses parmi les N périodes d'heures creuses, M étant supérieur à N. A titre d'exemple, N peut être fixé à 9.

Un tel mode de réalisation ne requiert pas de connaître le volume du ballon d'eau. Toutefois, il requiert de stocker la courbe de charge sur une période antérieure longue, par exemple de l'ordre de plusieurs mois.

L'exploitation de la valeur Pmax sera détaillée dans ce qui suit.

Le dispositif d'estimation 11 comprend en outre une unité de débruitage 13, dont l'utilisation est optionnelle dans le cadre de la présente invention.

L'unité de débruitage 13 permet de débruiter la courbe de charge reçue par l'unité de réception 12, par décomposition en ondelettes. La décomposition en ondelettes est une méthode de compression couramment utilisée en traitement du signal (par exemple dans la compression d'image avec l'algorithme de la norme « jpeg », ou sonore avec l'algorithme de compression audio « mp3 »). Elle consiste à décomposer un signal par superposition de fonctions simples.

Une description des transformées en ondelettes est présentée dans le « Guide utilisateur Gwyddion » de Petr Klapetek, David Necas et Christopher Andreson, traduction française par François Riguet, version du 14 janvier 2014, Chapitre 4, section « Transformée en ondelettes ».

L'application de la décomposition en ondelettes à un signal permet de gommer les amplitudes faibles du signal, tout en conservant les fortes amplitudes par seuillage.

Dans le cas présent, seule la fonction de seuillage peut être utilisée. A cet effet, des sous-routines utilisées en langage SAS/IML peuvent être utilisées. Elles mettent en oeuvre une transformée rapide en ondelettes, appelée WAVFT) qui calcule une transformée en ondelettes discrète en utilisant l'algorithme de Mallat.

La décomposition peut être paramétrée en sélectionnant le troisième membre des ondelettes de Daubechies, dont la forme des fonctions de base est bien connue de l'homme du métier.

Une fois la décomposition réalisée, il convient de conserver le premier niveau et de procéder à la reconstruction du signal (fonction WAVIFT, pour transformée inverse) après avoir procédé au seuillage des coefficients peu importants. Un seuillage doux de type « SureShrink » émanant du document « Adapting to unknwown smoothness via Wevelet shrinkage » de L.Donoho et M.Johnstone, Journal of the American Statistical Association, Vol. 90, No 432, décembre 1995, pages 1200 à 1224, peut être utilisé.

La courbe de charge reçue par l'unité de réception 12, et optionnellement débruitée par l'unité de débruitage 13, est transmise à une première unité de détermination 14 d'une enveloppe basse de la courbe de charge.

A cet effet, l'unité de détermination 14 peut construire une enveloppe basse à la courbe de charge en reliant les minima glissants sur 2n+1 pas demi-horaires centrés, n étant supérieur ou égal à 1. Par exemple, n peut être égal à 3.

Ainsi, pour chaque instant de la période donnée, la valeur minimale entre les valeurs respectives de la courbe de charge pour les n instants précédant l'instant donné, pour l'instant donné et pour les n instants suivant l'instant donné, est déterminée. Ceci requiert une connaissance de la valeur pour n instants précédant la période donnée et des n instants suivant la période donnée. A chaque instant donné est ensuite attribuée la valeur minimale déterminée. Les valeurs minimales sont alors reliées pour obtenir l'enveloppe basse de la courbe de charge.

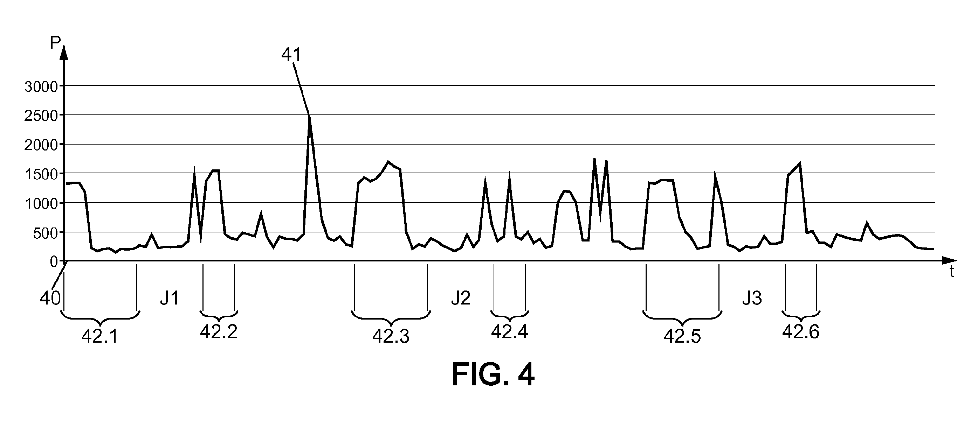

Les Figures 4 à 6 illustrent le fonctionnement de l'unité de détermination 14.

La Figure 4 est un diagramme 40 présentant la courbe de charge 41 sur une période donnée de trois jours, reçue par l'unité de détermination 14, la période donnée comprenant six périodes d'heures creuses référencées 42.1, 42.2, 42.3, 42.4, 42.5 et 42.6.

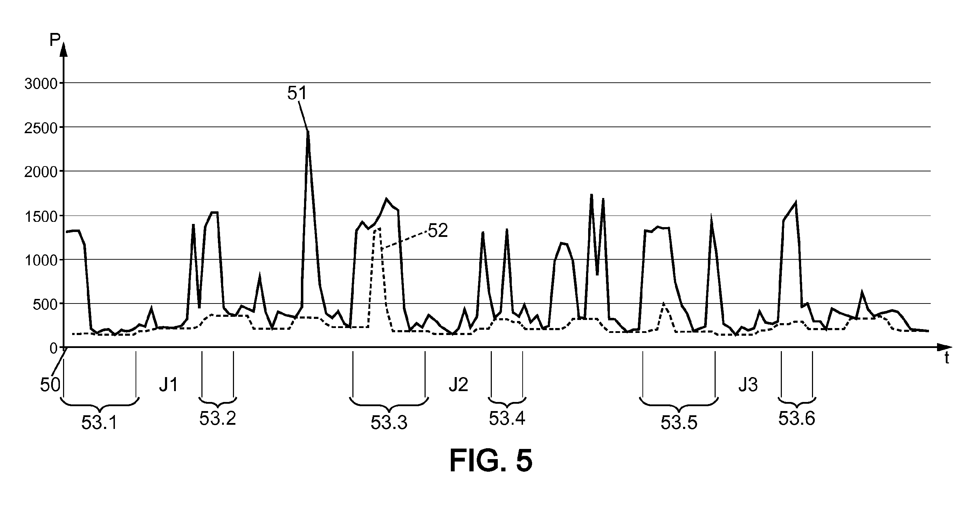

La Figure 5 est un diagramme 50 présentant la courbe de charge 51 (identique à la courbe de charge 41) sur la même période donnée de trois jours, comprenant les six périodes d'heures creuses qui sont référencées 53.1, 53.2, 53.3, 53.4, 53.5 et 53.6. Le diagramme 50 comprend en outre l'enveloppe basse 52 de la courbe de charge 51, déterminée de la manière précédemment décrite, avec un pas de 30 minutes et n égal à 3 (avec 7 minima glissants donc).

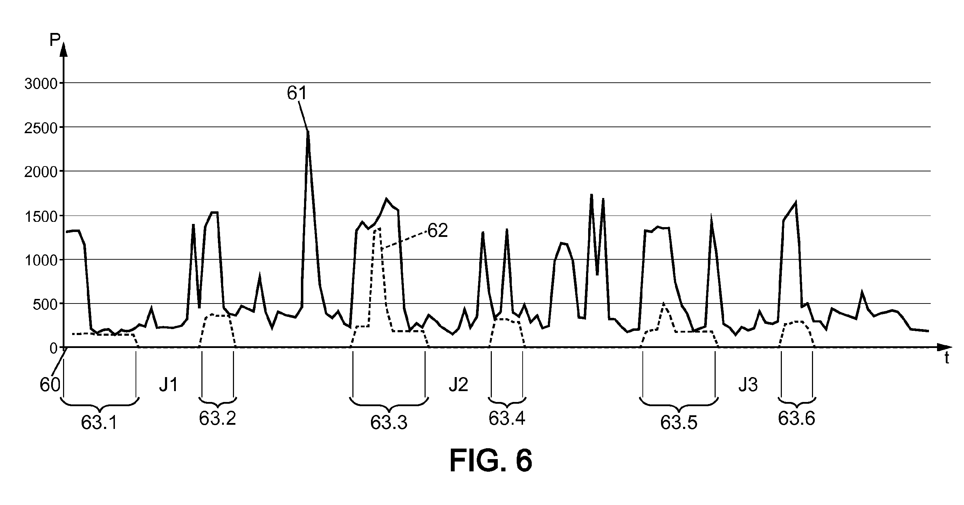

La Figure 6 est un diagramme 60 présentant la courbe de charge 61 (identique aux courbes de charge 51 et 41) sur la même période donnée de trois jours, comprenant les six périodes d'heures creuses qui sont référencées 63.1, 63.2, 63.3, 63.4, 63.5 et 63.6. Le diagramme 60 comprend en outre l'enveloppe basse 62 de la courbe de charge 61, déterminée de la manière précédemment décrite, avec un pas de 30 minutes et n égal à 3 (avec 7 minima glissants donc), et qui a été restreinte aux six périodes d'heures creuses comparativement à l'enveloppe basse 52 de la Figure 5. Une telle restriction aux périodes d'heures creuses est optionnelle selon l'invention. Toutefois, pour la suite de l'exposé, et à titre illustratif, une restriction des courbes aux heures creuses est considérée.

Le dispositif d'estimation comprend en outre une deuxième unité d'estimation 15 apte à estimer une courbe de la puissance électrique consommée par le ballon d'ECS sur la période donnée, par soustraction de l'enveloppe basse déterminée par l'unité de détermination 14, à la courbe de charge.

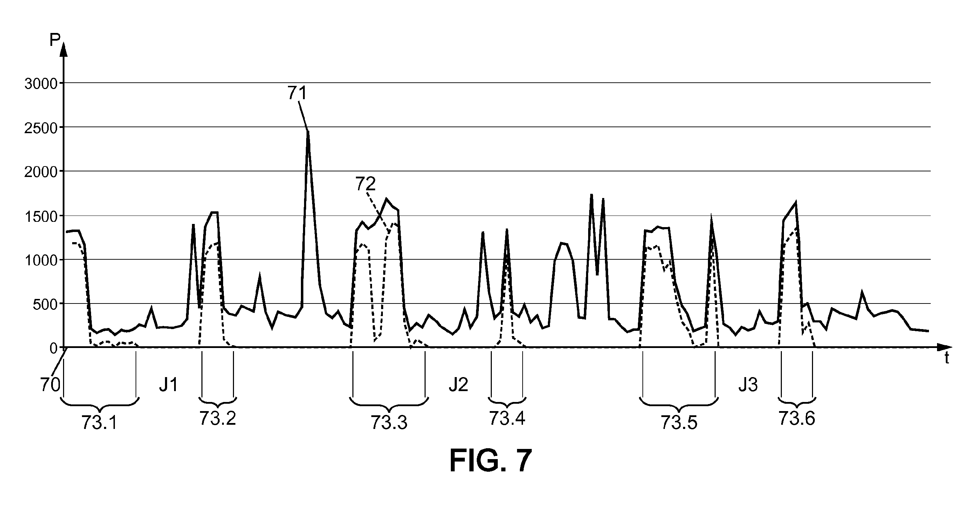

La courbe ainsi obtenue est présentée en référence à la Figure 7.

La Figure 7 est un diagramme 70 présentant la courbe de charge 71 (identique aux courbes de charge 41, 51 et 61) sur la même période donnée de trois jours, comprenant les six périodes d'heures creuses qui sont référencées 73.1, 73.2, 73.3, 73.4, 73.5 et 73.6. Le diagramme 70 présente en outre la courbe 72 de la puissance électrique consommée par le ballon d'ECS, estimée par la deuxième unité d'estimation 15.

Ainsi, le dispositif 11 permet d'obtenir la courbe de puissance consommée par le ballon d'ECS, à partir d'une courbe de charge globale, sans connaissance préalable sur les autres équipements du foyer, et avec un pas d'un ordre supérieur à la minute. L'utilisation de l'enveloppe basse de la courbe de charge dans le procédé d'estimation rend possible l'utilisation d'un tel pas supérieur à la minute.

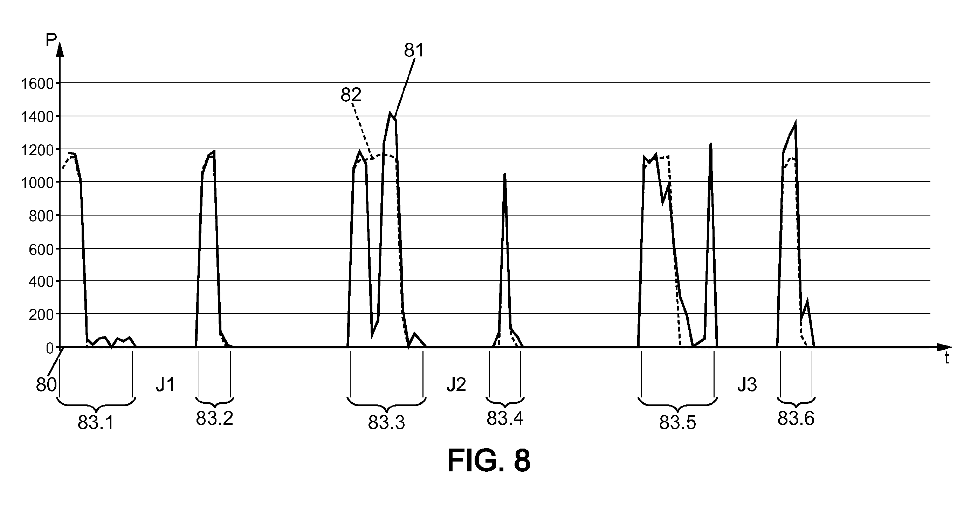

La Figure 8 est un diagramme 80 présentant l'estimation 81 de la courbe de la consommation électrique du ballon d'ECS sur la même période donnée de trois jours, comprenant les six périodes d'heures creuses qui sont référencées 83.1, 83.2, 83.3, 83.4, 83.5 et 83.6. L'estimation 81 est comparée à la consommation réelle 82 du ballon d'ECS sur la période donnée.

La suite de la description présente des unités complémentaires permettant d'apporter des correctifs à l'estimation 81, et d'ainsi améliorer la précision associée à l'estimation de la consommation électrique du ballon d'ECS. En particulier, l'estimation 81 obtenue par le dispositif d'estimation 11 est moins fiable pendant des périodes de chauffage électrique (par radiateurs électriques par exemple), dans la mesure où elle intègre cette consommation dans l'estimation de la consommation électrique du ballon d'ECS. En outre, l'estimation 81 surestime la puissance appelée lors d'un deuxième enclenchement du ballon d'ECS pendant une même période d'heures creuses.

L'ensemble des étapes correctrices est optionnel.

Une première étape correctrice peut être mise en oeuvre par une troisième unité d'estimation 18 du dispositif d'estimation 11. La troisième unité d'estimation 18 est apte à recevoir la valeur de la puissance Pmax de la première unité d'estimation 16. La première correction apportée par la troisième unité d'estimation 18 consiste à limiter la puissance consommée par le ballon d'ECS à des valeurs inférieures à la valeur de la puissance maximale Pmax, sur la période donnée, en vue d'obtenir une première courbe corrigée. On assure ainsi que la première courbe corrigée n'intègre pas les consommations dues au chauffage, en particulier pour le premier enclenchement du ballon d'ECS en périodes d'heures creuses. Un tel correctif peut être appliqué aussi bien aux périodes d'heures creuses méridiennes qu'aux périodes d'heures creuses nocturnes.

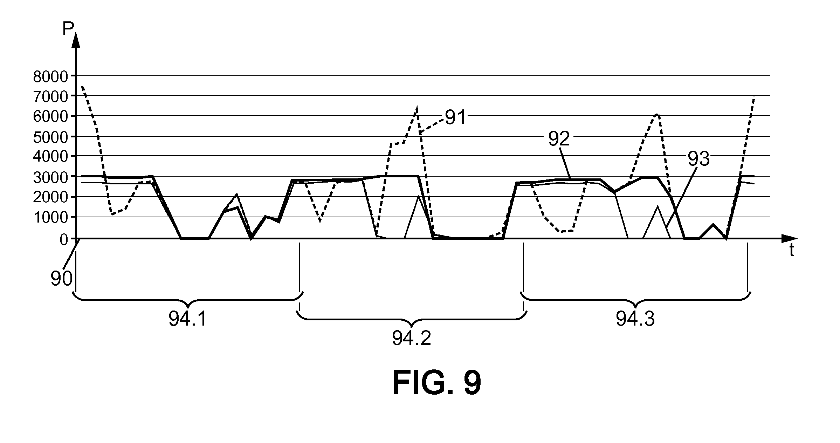

L'application du premier correctif est illustrée en référence à la Figure 9. La Figure 9 est un diagramme 90 présentant notamment l'estimation 91 de la consommation électrique du ballon d'ECS issue de la deuxième unité d'estimation 15, sans correctif, sur une période donnée de trois jours dont seules les périodes d'heures creuses respectives 94.1, 94.2 et 94.3 ont été représentées. Le diagramme 90 présente également la première courbe corrigée, référencée 92, pour laquelle la puissance a été limitée à la valeur Pmax. A titre de comparaison, le diagramme 90 présente enfin la consommation réelle 93 du ballon d'ECS sur la période donnée.

Dans la suite de l'exposé, on note $ECS_1(t)$ la première courbe corrigée. Toutefois, le premier correctif étant optionnel, $ECS_1(t)$ peut également désigner l'estimation 91 de la consommation électrique du ballon d'ECS issue de la deuxième unité d'estimation 15.

Le dispositif d'estimation 11 comprend en outre une quatrième unité d'estimation 19 apte à appliquer une deuxième correction à la courbe $ECS_1(t)$, en vue d'obtenir une deuxième courbe corrigée $ECS_2(t)$.

Lors d'un passage dans une période d'heures creuses, le ballon d'ECS est enclenché durant une première période d'enclenchement, qui dure généralement plus d'une heure et demie. Comme évoqué précédemment, l'enveloppe basse déterminée par l'unité de détermination 14 peut être construite sur les minima glissants avec n égal à 3. Pour déterminer l'enveloppe basse à un instant donné, il convient ainsi de prendre en compte la courbe de charge une heure et demie avant l'instant donné, et une heure et demi après l'instant donné (toujours en considérant un pas de 30 minutes).

Ainsi, une heure et demie après le début d'une période d'heures creuses, l'enveloppe basse coïncide sensiblement avec la courbe de charge, et l'estimation de la consommation électrique du ballon d'ECS, obtenue par différence de la courbe de charge et de l'enveloppe basse, est proche de zéro. L'estimation est donc faussée.

Le même problème se pose lorsque n est égal à 1 ou à 2.

Ainsi, la deuxième correction consiste à prolonger la période de premier enclenchement pour la courbe $ECS_1(t)$, tant qu'un taux de variation de la courbe de charge n'atteint pas une valeur suffisamment négative (par exemple -40%).

Le taux de variation de la courbe de charge, noté $\Delta P(t)$ est déterminé de la manière suivante :

$$\Delta P(t) = [P(t) - P(t-1) / P(t-1) \; ;$$

P(t) représentant la puissance consommée par l'ensemble d'équipements à l'instant donné t et P(t-1) représentant la puissance consommée par l'ensemble d'équipements à l'instant t-1 précédant directement l'instant donné t.

On note en outre $t_0$ l'instant de début d'une période d'heures creuses et on initialise une variable ECS_plateau à la valeur de la courbe $ECS_1$ à l'instant $t_0$.

La deuxième courbe corrigée est notée $ECS_2$ et est obtenue de la manière suivante, pour tous les instants t suivant l'instant $t_0$ de la période d'heures creuses:

- si $t < t_0 + th_1$, et si $|\Delta P(t)| < th_2$, alors $ECS_2(t) = Max(ECS\_plateau*(1+\Delta P(t) \; ; ECS_1(t))$
- sinon,

    o si $t \geq t_0 + th_1$ et $|\Delta P(t)| < th_3$, alors $ECS_2(t) = ECS_1(t)$ et ECS_plateau=$ECS_1(t)$ ;
    o sinon,

        ■ si $\Delta P(t) < -th_4$ ou $\Delta P(t) > th_2$ alors $ECS_2(t) = ECS_1(t)$ et ECS_plateau est mis à jour à la valeur $ECS_1(t)$ pour les instants suivant l'instant t dans la période d'heures creuses;
        ■ sinon $ECS_2(t) = ECS_1(t)$ ;

Dans les formules ci-dessus, Max(A,B) désigne la valeur maximale entre A et B. Dans les algorithmes présentés dans la présente demande, la notation C=D indique que la valeur de D est affectée à C.

$th_1$ est un seuil prédéterminé, exprimé en heures, et pouvant être fixé à 4 heures par exemple, dans le cadre d'un pas égal à 30 minutes.

$th_2$, $th_3$ et $th_4$ sont également des seuils prédéterminés de taux de variation, sont exprimés en pourcentages et $th_3$ est inférieur à $th_2$.

A titre d'exemple, dans le cadre d'un pas horaire à 30 minutes, $th_2$ peut être égal à 15%, $th_3$ peut être égal à 5% et $th_4$, comme précédemment évoqué, peut être égal à 40%.

Ainsi, à l'issue de la deuxième correction, la deuxième courbe corrigée $ECS_2(t)$ est obtenue.

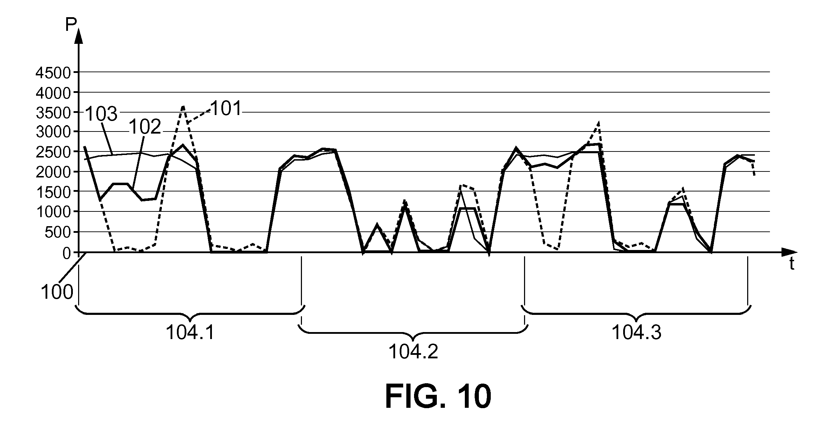

La Figure 10 est un diagramme 100 présentant l'estimation 101 de la consommation électrique du ballon d'ECS, sans aucune correction, sur une période donnée de plusieurs jours, seules les périodes d'heures creuses 104.1, 104.2 et 104.3 ayant été représentées.

L'estimation 101 présentent des creux atteignant une puissance nulle, environ une heure et demi après le début de la première période d'heures creuses 104.1 et une heure et demie après le début de la troisième période d'heures creuses 104.3.

Le diagramme 100 montre en outre la deuxième courbe corrigée $ECS_2(t)$, référencée 102, sur laquelle les creux de l'estimation 101 ont été corrigés afin de se rapprocher de la consommation réelle 103 du ballon d'ECS.

La quatrième unité d'estimation 19 peut en outre appliquer une troisième correction à la deuxième courbe corrigée $ECS_2$, en vue d'obtenir une troisième courbe corrigée, notée $ECS_3$.

En effet, en référence à la Figure 10, la deuxième courbe corrigée présente tout de même des creux (notamment durant la première période d'heures creuses 104.1) qui ne correspondent pas à la consommation réelle 103.

Ainsi, l'invention peut prévoir une interpolation linéaire pour les valeurs de puissances consommées de la deuxième courbe corrigée $ECS_2$ qui sont inférieures au tiers de la puissance maximale Pmax du ballon d'ECS et qui sont encadrées par de fortes puissances consommées par le ballon d'ECS sur la deuxième courbe corrigée $ECS_2$, si elles se situent dans les $th_1$ premières heures d'une période d'heures creuses (en particulier des heures creuses nocturnes).

Ainsi, la deuxième courbe corrigée peut être obtenue de la manière suivante, pour tous les instants t suivant l'instant antérieurs à l'instant $t_0+th_1$: si $ECS_2(t) < \dfrac{Pmax}{3}$, si $ECS_2(t-1) > \dfrac{2*Pmax}{3}$ et si $ECS_2(t+1) > \dfrac{2*Pmax}{3}$ alors $ECS_3(t) = \dfrac{ECS_2(t-1) + ECS_2(t+1)}{2}$ ; sinon, $ECS_3(t) = ECS_2(t)$.

A nouveau, on peut considérer un seuil $th_1$ égal à 4 heures.

En complément, la quatrième unité d'estimation 19 peut borner la troisième courbe corrigée $ECS_3$ en fin de période d'heures creuses.

En effet, en fin de période d'heures creuses méridiennes ou nocturnes, il peut être considéré qu'il ne peut y avoir d'augmentation de la puissance consommée par le ballon d'ECS durant le dernier pas de 30 minutes.

En notant $t_f$ l'instant de fin d'une plage d'heures creuses (par exemple pour une plage d'heures creuses de nuit, on peut considérer $t_f = t_0 + 8$ heures) ; et $t_f$-1 l'instant précédant directement l'instant $t_f$ (soit 30 minutes avant $t_f$ dans l'exemple considéré).

La troisième courbe peut alors être corrigée de la manière suivante :

Si $ECS_3(t_f) > ECS_3(t_f-1)$ alors $ECS_3(t_f) = ECS_3(t_f-1)$.

Le dispositif d'estimation 11 comprend en outre une cinquième unité d'estimation 20 apte à appliquer une quatrième correction à la troisième courbe corrigée $ECS_3(t)$, en vue d'obtenir une quatrième courbe corrigée $ECS_4(t)$. La troisième correction précédemment appliquée étant optionnelle, la quatrième correction peut être appliquée à la deuxième courbe corrigée $ECS_2(t)$, voire à l'estimation $ECS_1(t)$. Dans ce qui suit, la quatrième correction est appliquée à la troisième courbe corrigée $ECS_3(t)$, à titre illustratif.

On rappelle que le ballon d'ECS fonctionne par périodes d'enclenchement comprises dans une période d'heures creuses de la période donnée. Durant les périodes d'heures creuses nocturnes notamment, il apparaît fréquemment qu'un deuxième enclenchement est prévu lorsque la température de l'eau dans le ballon d'ECS est retombée à une valeur inférieure à un seuil prédéterminé par exemple.

Ainsi, le quatrième correctif est applicable dans une période d'heures creuses comprenant au moins une première période d'enclenchement et une deuxième période d'enclenchement.

Usuellement, le ballon d'ECS est enclenché en début de période d'heures creuses, puis s'arrête une fois une température de consigne atteinte. Les déperditions de chaleur pendant la nuit entrainent mécaniquement une baisse de la température de l'eau dans le ballon d'ECS. Le ballon d'ECS est enclenché une deuxième fois en fin de période d'heures creuses nocturnes, généralement sur une deuxième période d'enclenchement plus courte que la première période d'enclenchement, afin de réchauffer l'eau à la température voulue. Un tel phénomène peut par exemple apparaître lorsqu'un membre du foyer se lève et se lave très tôt.

De plus, dans la pratique, l'estimation du premier enclenchement est plus précise que celle du deuxième enclenchement. En effet, l'appel de puissance en début de période d'heures creuses est plus facile à détecter car il est synchronisé avec un signal tarifaire de passage en heures creuses, sans que d'autres usages viennent bruiter la courbe de charge.

Afin d'améliorer l'estimation du deuxième enclenchement, l'invention peut prévoir d'utiliser des distributions de ratios entre la puissance maximale atteinte lors du deuxième enclenchement et la puissance maximale atteinte lors du premier enclenchement, en vue de choisir un quantile de ce ratio pour borner l'estimation du second enclenchement.

La quatrième correction vise à améliorer l'estimation concernant le deuxième enclenchement du ballon d'ECS.

Un algorithme de détection de pics peut permettre de distinguer la première période d'enclenchement des périodes d'enclenchement suivantes, et peut permettre de déterminer la valeur maximale de la puissance pendant la première période d'enclenchement.

Ensuite, tant que la puissance consommée est supérieure à une fraction de la puissance maximale du premier enclenchement (par exemple supérieure à la moitié de la puissance maximale du premier enclenchement), il peut être considéré que la période de premier enclenchement se poursuit.

Une fois que la puissance descend en-dessous de la fraction précitée, les appels de puissance suivants sont considérés comme des relances faisant donc partie de la deuxième période d'enclenchement.

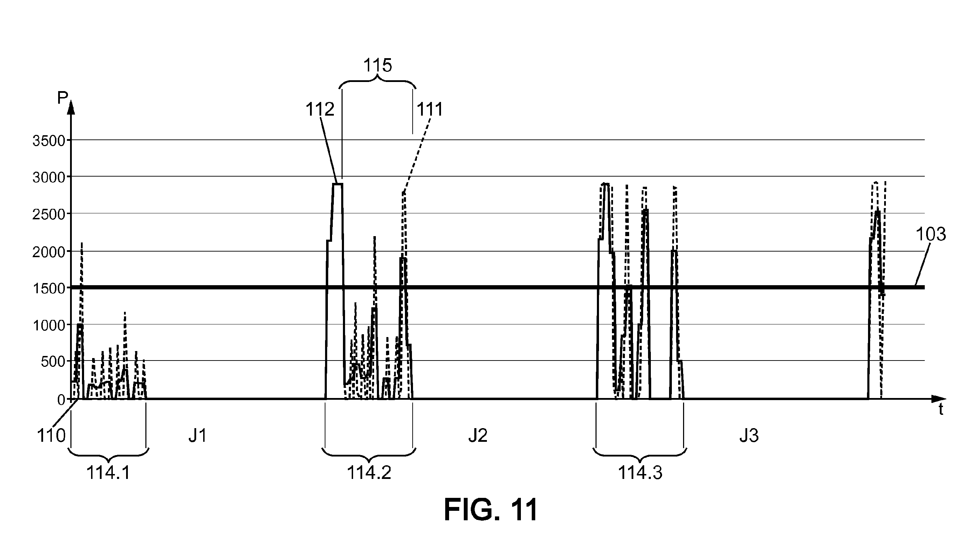

A cet effet, la figure 11 est un diagramme 110 présentant sur trois jours consécutifs, comprenant trois période d'heures creuses 114.1, 114.2 et 114.3, l'évolution de la consommation réelle du ballon d'ECS, avec un pas de 10 minutes (courbe 111) et avec un pas de 30 minutes (courbe 112). Des courbes de consommation réelles (et non des estimations ou des corrections d'estimation) sont utilisées afin de déterminer la valeur correspondant à la fraction (la moitié par exemple) de la puissance maximale du premier enclenchement. Dans l'exemple présenté, la valeur est prise égale à 1500 W. Ainsi, la deuxième période d'heures creuses 114.2 présente une deuxième période d'enclenchement référencée 115, qui commence lorsque la courbe 112 ou 111, après avoir dépassé une première fois la valeur 1500 W, redescend en dessous de cette valeur.

L'instant de début de la deuxième période d'enclenchement 115 est noté $t_1$. Cet instant constitue un instant de démarcation entre la première période d'enclenchement et la deuxième période d'enclenchement, pour une période d'heures creuses.

Ainsi, une fois que l'instant $t_1$ a été déterminé, il est possible de déterminer, sur les courbes de consommations réelles 111 et 112, le maximum de puissance atteint par enclenchement.

A cet effet, une valeur médiane du ratio des puissances maximales réelles entre le premier enclenchement et le second enclenchement peut être déterminée en fonction :

- du type de client (nocturne (1 plage), méridien (2 plages), méridien (3 plages)). En effet, les heures creuses comportent généralement huit heures par jour pendant lesquelles un client dispose d'un tarif réduit pour ses consommations d'électricité. Ces 8 heures peuvent être consécutives la nuit pour les clients de type nocturne (en général de 22h à 6h). Alternativement, les huit heures peuvent être morcelées en 2 ou 3 plages (dont 1 ou 2 intervient en période méridienne). Dans ce cas, 6 heures d'heures creuses peuvent être prévues la nuit et 2 heures d'heures creuses peuvent être prévues entre 12h et 17h (heures creuses méridiennes) ;
- du volume total du ballon d'ECS (200 L ou moins, de 201 L à 300 L, ou plus de 300 L) ;
- de la saison et du type de jour. Le type de jour est le jour pendant lequel une période d'heures creuses nocturnes débute. Par exemple, pour une période d'heures creuses du lundi 22h au mardi 6h, le type de jour est lundi.

Ainsi, la quatrième correction consiste à borner le second enclenchement dans la troisième courbe corrigée ECS3(t), à la valeur maximale de la troisième courbe corrigée ECS3(t) lors de la première période d'enclenchement, pondérée par la médiane du groupe auquel appartient le foyer. La médiane constitue ainsi un plafond noté $th_{second}$ dans ce qui suit.

La quatrième courbe corrigée $ECS_4$ est ainsi obtenue de la manière suivante :

- pour $t \in [t_0;t_1]$, $ECS_4(t) = ECS_3(t)$ ;

- pour $t \in \left]t_1;t_f\right]$, $ECS_4(t) = Min\left\{\underset{t<t_1}{Max}\left\{ECS_3(t)\right\} \times th_{second};ECS_3(t)\right\}$, Min(A;B) désignant le minimum entre A et B.

$ECS_3(t)$ peut indifféremment être remplacé dans l'algorithme précédent par $ECS_2(t)$ ou $ECS_1(t)$, selon les correctifs apportés à l'estimation faite par la deuxième unité d'estimation 15.

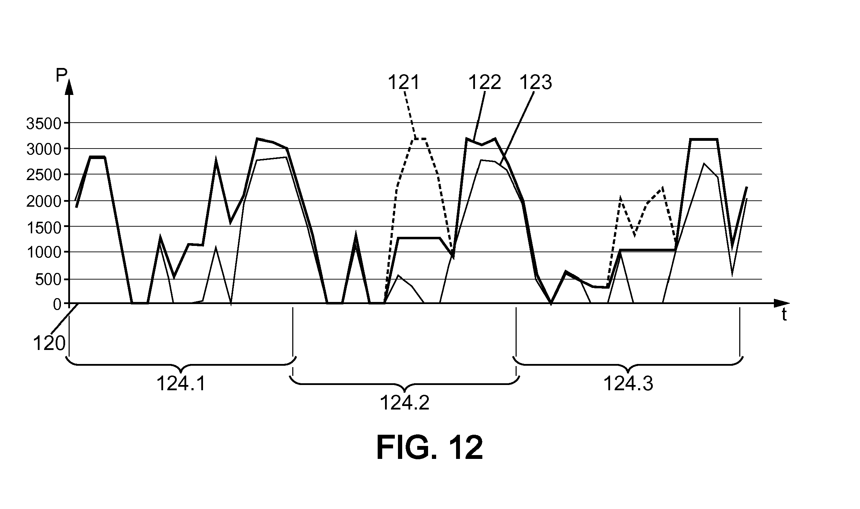

Afin d'illustrer la contribution de la quatrième correction, la Figure 12 est un diagramme 120 présentant l'estimation 121 de la consommation électrique du ballon d'ECS, sans aucune correction, sur une période donnée de plusieurs jours, seules les périodes d'heures creuses 124.1, 124.2 et 124.3 ayant été représentées. Il peut être constaté que lors de la deuxième période d'heures creuses 124.2, un pic de puissance supérieur à 3000 W est atteint par la courbe 121, durant une deuxième période d'enclenchement, et qui est éloigné de la courbe réelle de consommation du ballon d'eau, référencée 123.

La quatrième courbe corrigée $ECS_4(t)$ est référencée 122 et un palier peut être observé durant la deuxième période d'enclenchement pendant la deuxième période d'heures creuses 124.2, à la place du pic de puissance de l'estimation 121.

L'estimation de la courbe de la consommation électrique du ballon d'ECS est donc considérablement améliorée par l'application de la quatrième correction.

La courbe de la consommation électrique du ballon d'ECS ainsi estimée et éventuellement corrigée peut permettre de faire des prévisions du fonctionnement du ballon d'ECS par périodes d'heures creuses. A cet effet, la courbe de la consommation électrique estimée et éventuellement corrigée est transmise par une unité de transmission 21 du dispositif d'estimation 11, à une unité de prévision 22. Il est ainsi possible de construire un modèle de prévision de la durée de fonctionnement du ballon d'ECS par période d'heures creuses.

A cet effet, une méthode alternative à la régression linéaire peut être employée : la régression quantile.

La régression quantile permet de prévoir non pas la moyenne d'une variable d'intérêt, mais un quantile (par exemple la médiane).

Avantageusement, et étant donné que la méthode d'estimation décrite précédemment surestime les durées de fonctionnement du ballon d'ECS, une régression quantile utilisant un percentile à 40% permet de corriger ce biais, afin d'avoir, en cumulant l'erreur d'estimation et l'erreur du modèle de prévision une erreur centrée en zéro.

Des variables sont sélectionnées pour la régression quantile. Il peut s'agir des variables significatives à un certain niveau de probabilité pour le quantile utilisé. A titre d'exemple, les variables les plus régulières et observées pour le plus grand nombre de clients sont, dans cet ordre :

- pour les clients nocturnes : consommation générale de la veille, saisonnalité, durée d'utilisation du ballon d'ECS de la veille et de l'avant-veille, type de jour (jours de début d'heures creuses), durée d'utilisation du ballon d'ECS à J-3, consommation générale de l'avant-veille puis toutes les durées d'utilisation du ballon d'ECS jusqu'à J-7 et la durée d'utilisation du ballon d'ECS à J-14 ;
- pour la période d'heures creuses nocturnes des clients méridiens : la durée d'utilisation du ballon d'ECS, consommation générale de la veille, saisonnalité, durée d'utilisation du ballon d'ECS dans la période d'heures creuses nocturnes de l'avant-veille, les jours de début d'heures creuses (dimanche soir et mardi soir) ;
- pour la période d'heures creuses méridiennes des clients méridiens :

  saisonnalité, jours de début d'heures creuses de fin de semaine (du jeudi soir au dimanche soir), durée d'utilisation du ballon d'ECS de la période d'heures creuses nocturnes de la veille, consommation générale de la veille.

La prévision de la durée de fonctionnement du ballon d'ECS dépend fortement de la saison. Ainsi, selon le mois pendant lequel la prévision est effectuée, l'instant de départ de la période d'apprentissage peut varier. A titre d'exemple, en vue de prévoir les durées de fonctionnement pour les mois de janvier à avril, des historiques de courbes de charge commençant en octobre peuvent être utilisés.

En outre, le quantile à prévoir pour la régression peut dépendre du client et du mois. La dépendance précitée est illustrée en référence au Tableau 1 ci-dessous :

Tableau 1 : Détermination d'un quantile en fonction du type de client et du mois à prévoir.

| Mois | Début de période d'apprentissage | Clients Nocturnes | Clients Méridiens | |
|---|---|---|---|---|
| | | Période nocturne | Période nocturne | Période méridienne |
| **Janvier** | Octobre | 0.35 | 0.50 | 0.50 |
| **Février** | Octobre | 0.40 | 0.40 | 0.50 |
| **Mars** | Octobre | 0.45 | 0.50 | 0.50 |
| **Avril** | Octobre | 0.50 | 0.50 | 0.50 |
| **Mai** | Février | 0.50 | 0.50 | 0.60 |
| **Juin** | Mars | 0.50 | 0.50 | 0.50 |
| **Juillet** | Avril | 0.50 | 0.50 | 0.50 |
| **Août** | Mai | 0.50 | 0.50 | 0.50 |
| **Septembre** | Mai | 0.50 | 0.50 | 0.50 |
| **Octobre** | Mai | 0.50 | 0.50 | 0.50 |
| **Novembre** | Juillet | 0.40 | 0.50 | 0.50 |
| **Décembre** | Septembre | 0.30 | 0.40 | 0.50 |

Par exemple, pour un client nocturne et pour une estimation du mois de janvier, la période d'apprentissage débute en octobre et le percentile à 35% est utilisé pour la régression quantile.

Une fois les variables d'entrée sélectionnées et les quantiles à estimer déterminés, l'estimation des paramètres est faite non pas avec les moindres carrés ordinaire comme en régression linéaire, mais à l'aide d'un algorithme d'optimisation. De tels algorithmes d'optimisation sont bien connus de l'homme du métier.

Un modèle de prédiction plus simple consiste à considérer que la durée de fonctionnement au jour J+1 est égale à la durée de fonctionnement au jour J.

A partir de l''estimation, éventuellement corrigée, de la consommation électrique d'un équipement donné parmi un ensemble d'équipements, les applications suivantes peuvent être prévues et mises en oeuvre par une unité applicative 23 :

- en cas de production d'énergie solaire (photovoltaïque), déplacement des heures de fonctionnement du ballon d'ECS vers des heures de plein ensoleillement ;
- optimisation de la courbe de charge générale en déplaçant la consommation électrique du ballon d'ECS en fin de période d'heures creuses nocturnes, où les coûts d'approvisionnement sont moins élevés ;
- fourniture d'une facture détaillée aux clients finaux, par usage, et de conseils et diagnostics sur l'utilisation du ballon d'ECS.

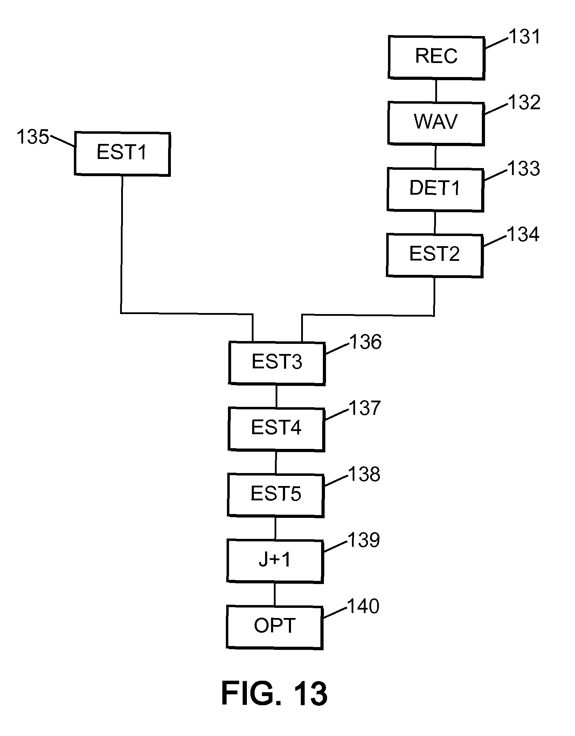

La figure 13 est un diagramme illustrant les étapes d'un procédé selon un mode de réalisation de l'invention.

A une étape 131, la courbe de charge est reçue par l'unité de réception 12.

A une étape 132, une étape optionnelle de débruitage de la courbe de charge peut être appliquée par l'unité de débruitage 13, tel que précédemment détaillé.

A une étape 133, une enveloppe basse de la courbe de charge est déterminée par l'unité de détermination 14, de la manière décrite dans l'exposé qui précède.

A une étape 134, une courbe de la puissance électrique consommée par l'équipement électrique donné sur la période donnée est estimée par soustraction de l'enveloppe basse déterminée à la courbe de charge. Comme précédemment expliqué, l'étape 134 peut être mise en oeuvre par la deuxième unité d'estimation 15.

A une étape 135, la puissance maximale Pmax consommée par l'équipement donné est estimée par la première unité d'estimation 16, selon l'une des deux méthodes décrites précédemment.

A une étape 136 optionnelle, une première correction est appliquée à la courbe de la consommation électrique estimée à l'étape 134, par la troisième unité d'estimation 18, au moyen notamment de la puissance maximale Pmax estimée à l'étape 135. Une première courbe corrigée est obtenue.

A une étape 137 optionnelle, une deuxième et/ou une troisième correction est appliquée à la courbe $ECS_1(t)$ (première courbe corrigée ou courbe estimée sans correction), par la quatrième unité d'estimation 19, en vue d'obtenir une deuxième courbe corrigée $ECS_2(t)$ ou une troisième courbe corrigée $ECS_3(t)$.

A une étape 138 optionnelle, une quatrième correction peut être appliquée à la courbe $ECS_1(t)$, à la deuxième courbe corrigée $ECS_2(t)$ ou à la troisième courbe corrigée $ECS_3(t)$, par la cinquième unité d'estimation 20, en vue d'obtenir une quatrième courbe corrigée $ECS_4(t)$, tel que décrit précédemment.

A une étape 139 optionnelle, une prévision de la durée de fonctionnement de l'équipement électrique donnée peut être obtenue par l'unité de prévision 22, à partir de l'une des courbes $ECS_1(t)$, $ECS_2(t)$, $ECS_3(t)$ et $ECS_4(t)$.

A une étape 140 optionnelle, l'une des applications de l'invention précédemment citées peut être mise en oeuvre par l'unité applicative 23.

## Revendications

**1.** Procédé d'estimation de la consommation électrique d'un équipement électrique donné parmi un ensemble d'équipements électriques, comprenant les étapes suivantes mises en oeuvre par un dispositif d'estimation (11) :

- réception (131) d'une courbe de charge représentative de la consommation électrique dudit ensemble d'équipements électriques à des instants donnés, sur une période donnée ;
- détermination (133) d'une enveloppe basse de ladite courbe de charge ;
- estimation (134) d'une courbe de la puissance électrique consommée par l'équipement électrique donné sur la période donnée, par soustraction de l'enveloppe basse déterminée à ladite courbe de charge ;

dans lequel la courbe de charge est en outre reçue pour des périodes précédant et suivant la période donnée, le procédé étant **caractérisé en ce que** l'étape de détermination (133) de l'enveloppe basse de la courbe de charge comprend les étapes suivantes, pour chaque instant de la période donnée :

- déterminer la valeur minimale entre les valeurs de la courbe de charge respectives pour les n instants précédant l'instant donné, pour l'instant donné et pour les n instants suivant l'instant donné, n étant entier supérieur ou égal à un ;
- attribuer audit instant la valeur minimale déterminée,

lesdites valeurs minimales étant reliées pour obtenir l'enveloppe basse de la courbe de charge.

2. Procédé selon la revendication 1, dans lequel les instants donnés sont espacés à intervalles réguliers, lesdits intervalles réguliers étant supérieurs à une minute.

3. Procédé selon la revendication 1 ou 2, dans lequel l'équipement électrique donné est un ballon d'eau chaude sanitaire et dans lequel la période donnée comprend au moins une période d'heures creuses, et dans lequel l'estimation de la courbe de la puissance électrique consommée par l'équipement électrique est restreinte à ladite au moins une période d'heures creuses.

4. Procédé selon l'une des revendications précédentes, comprenant en outre une étape d'estimation (135) de la puissance maximale consommée par ledit équipement donné, et une étape d'application (136) d'une première correction à ladite courbe estimée, en vue d'obtenir une première courbe corrigée, ladite première correction consistant à limiter la puissance consommée par ledit appareil électrique à des valeurs inférieures à ladite puissance maximale, sur la période donnée.

5. Procédé selon les revendications 3 et 4, dans lequel le volume du ballon d'eau chaude sanitaire est connu, et dans lequel la puissance maximale consommée est estimée à partir dudit volume.

6. Procédé selon la revendication 4, dans lequel une courbe de charge continue représentant la consommation électrique de l'ensemble des équipements pour une période antérieure à ladite période donnée est stockée, ladite période antérieure étant continue et comprenant au moins des périodes d'heures creuses et d'heures pleines, et dans lequel l'étape d'estimation (135) de la puissance maximale consommée par ledit équipement électrique comprend :

- déterminer, pour chaque période d'heures creuses antérieure, la différence entre la valeur de la courbe de charge au premier instant ou au deuxième instant de ladite période d'heures creuses et la valeur de la courbe de charge à l'instant précédant directement ledit premier instant ;
- estimer, à partir des différences déterminées, la puissance maximale consommée par ledit équipement électrique.

7. Procédé selon l'une des revendications précédentes, dans lequel, sur réception de la courbe de charge, la procédé comprend l'application (132) d'une décomposition en ondelettes afin d'obtenir une courbe de charge débruitée, et dans lequel l'enveloppe basse est déterminée à partir de la courbe de charge débruitée, et la courbe de puissance électrique consommée par l'équipement donné est estimée par soustraction de l'enveloppe basse à la courbe de charge débruitée, sur la période donnée.

8. Procédé selon la revendication 7, dans lequel un taux de variation T[P(t)] de la courbe de charge à un instant t donné de la période donnée est déterminé de la manière suivante :

$$T[P(t)] = [P(t) - P(t-1) / P(t-1)$$

P(t) représentant la puissance consommée par l'ensemble d'équipements à l'instant donné t et P(t-1) représentant la puissance consommée par l'ensemble d'équipements à l'instant t-1 précédant directement l'instant donné t ;
ledit procédé comprenant en outre une étape d'application (137) d'une deuxième correction à ladite courbe estimée, notée $ECS_1$, en vue d'obtenir une deuxième courbe corrigée, notée $ECS_2$,
$t_0$ étant l'instant de début d'une période d'heures creuses de la période donnée, une variable ECS_plateau étant initialisée à la valeur de la courbe estimée $ECS_1$ à l'instant $t_0$,
ladite deuxième courbe corrigée étant obtenue de la manière suivante, pour tous les instants t suivant l'instant $t_0$ de ladite période d'heures creuses:

- si $t<t_0+th_1$ et si $|T[P(t)]|<th_2$, alors $ECS_2(t)=Max(ECS\_plateau*(1+T[P(t)]$ ; $ECS_1(t))$
- sinon,

   ○ si $t\geq t_0+th_1$ et $|T[P(t)]|<th_3$, alors $ECS_2(t)=ECS_1(t)$ et $ECS\_plateau=ECS_1(t)$ ;
   ○ sinon,

      ■ si $T[P(t)]< -th_4$ ou $T[P(t)]>th_2$ alors $ECS_2(t)=ECS_1(t)$ et $ECS\_plateau$ est mis à jour à la valeur $ECS_1(t)$ pour les instants suivant l'instant t dans la période d'heures creuses;
      ■ sinon $ECS_2(t)=ECS_1(t)$ ;

dans lequel $Max(A,B)$ désigne la valeur maximale entre A et B ;
dans lequel $th_1$ est un seuil prédéterminé exprimé en heures,
dans lequel $th_2$, $th_3$ et $th_4$ sont des seuils prédéterminés exprimés en pourcentages, $th_3$ étant inférieur à $th_2$.

9. Procédé selon les revendications 4 et 8, dans lequel la puissance maximale consommée par ledit équipement donné est notée Pmax, dans lequel le procédé comprend en outre une étape d'application (137) d'une troisième correction à la deuxième courbe corrigée $ECS_2$, en vue d'obtenir une troisième courbe corrigée, notée $ECS_3$, ladite troisième courbe corrigée étant obtenue de la manière suivante, pour tous les instants t antérieurs à l'instant $t_0 +th_1$:

$$\text{si } ECS_2(t)<\frac{Pmax}{3}, \text{ si } ECS_2(t-1)> \frac{2*Pmax}{3} \text{ et si } ECS_2(t+1)> \frac{2*Pmax}{3}$$

$$\text{alors } ECS_3(t)= \frac{ECS_2(t-1)+ECS_2(t+1)}{2} ;$$

sinon, $ECS_3(t) = ECS_2(t)$.

10. Procédé selon la revendication 8 ou 9, dans lequel ledit équipement donné fonctionne par périodes d'enclenchement comprises dans une période d'heures creuses de la période donnée, dans lequel la puissance électrique est consommée par l'équipement électrique donné uniquement durant les périodes d'enclenchement, la période d'heures creuses comprenant au moins une première période d'enclenchement et une deuxième période d'enclenchement, dans lequel le procédé comprend en outre l'application (138) d'une quatrième correction à la deuxième courbe corrigée $ECS_2$, en vue d'obtenir une quatrième courbe corrigée, notée $ECS_4$, ladite quatrième correction comprenant :

- détermination d'un instant $t_1$ de démarcation entre la première période d'enclenchement et la deuxième période d'enclenchement;
- détermination d'un plafond $th_{second}$ de second enclenchement, étant exprimé en pourcentages ;

et la quatrième courbe corrigée $ECS_4$ étant obtenue de la manière suivante :

- pour $t \in [t_0;t_1]$, $ECS_4(t) = ECS_2(t)$ ;

$$\text{- pour } t\in \left]t_1;t_f\right], ECS_4(t) = Min\left\{\underset{t<t_1}{Max}\{ECS_2(t)\}\times th_{second};ECS_2(t)\right\}$$

$Min(A ;B)$ désignant le minimum entre A et B ;
$t_f$ étant un instant de fin de la période donnée.

11. Procédé selon les revendications 9 et 10, dans lequel la quatrième correction est appliquée à la troisième courbe corrigée $ECS_3$.

12. Procédé selon l'une des revendications précédentes, le procédé comprenant en outre la prévision (139) d'une durée de fonctionnement de l'équipement électrique donnée pour une période postérieure à la période donnée, en fonction de la courbe de la puissance électrique consommée par l'équipement électrique sur la période donnée.

**13.** Produit programme d'ordinateur comprenant des instructions de code de programme enregistrées sur un support lisible par un ordinateur, pour l'exécution des étapes du procédé selon l'une quelconque des revendications 1 à 12.

**14.** Dispositif d'estimation de la consommation électrique d'un équipement électrique donné parmi un ensemble d'équipements électriques, comprenant les unités suivantes :

- une unité de réception (12) d'une courbe de charge représentative de la consommation électrique dudit ensemble d'équipements électriques à des instants donnés, sur une période donnée ;
- une unité de détermination (14) d'une enveloppe basse de ladite courbe de charge ;
- une unité d'estimation (15) d'une courbe de la puissance électrique consommée par l'équipement électrique sur la période donnée, par soustraction de l'enveloppe basse déterminée à ladite courbe de charge ;

dans lequel la courbe de charge est en outre reçue pour des périodes précédant et suivant la période donnée, le dispositif étant **caractérisé en ce que** l'unité de détermination de l'enveloppe basse de la courbe de charge est en outre configuré pour, pour chaque instant de la période donnée :

- déterminer la valeur minimale entre les valeurs de la courbe de charge respectives pour les n instants précédant l'instant donné, pour l'instant donné et pour les n instants suivant l'instant donné, n étant entier supérieur ou égal à un ;
- attribuer audit instant la valeur minimale déterminée,

lesdites valeurs minimales étant reliées pour obtenir l'enveloppe basse de la courbe de charge.

**Patentansprüche**

**1.** Verfahren zur Abschätzung des Stromverbrauchs eines gegebenen elektrischen Geräts aus einer Einheit elektrischer Geräte, das die folgenden Schritte umfasst, die von einer Schätzungsvorrichtung (11) umgesetzt werden:

- Empfang (131) einer Ladungskurve, die den Stromverbrauch der Einheit elektrischer Geräte in gegebenen Augenblicken während einer gegebenen Zeitspanne darstellt,
- Bestimmung (133) einer unteren Hüllkurve der Ladungskurve,
- Abschätzung (134) einer Kurve der elektrischen Leistung, die von dem gegebenen elektrischen Gerät während der gegebenen Zeitspanne verbraucht wird, durch Subtraktion der bestimmten unteren Hüllkurve von der Ladungskurve,

wobei die Ladungskurve außerdem für Zeitspannen vor und nach der gegebenen Zeitspanne empfangen wird, wobei das Verfahren **dadurch gekennzeichnet ist, dass** der Schritt (133) der Bestimmung der unteren Hüllkurve der Ladungskurve die folgenden Schritte für jeden Augenblick der gegebenen Zeitspanne umfasst:

- Bestimmen des Mindestwerts unter den Werten der jeweiligen Ladungskurve für die n Augenblicke, die dem gegebenen Augenblick vorausgehen, für den gegebenen Augenblick und für die n Augenblicke, die auf den gegebenen Augenblick folgen, wobei n eine Ganzzahl größer oder gleich eins ist,
- Zuweisen des bestimmten Mindestwerts zu dem Augenblick,

wobei die Mindestwerte verbunden werden, um die untere Hüllkurve der Ladungskurve zu erhalten.

**2.** Verfahren nach Anspruch 1, wobei die gegebenen Augenblicke in regelmäßigen Intervallen beabstandet sind, wobei die regelmäßigen Intervalle größer sind als eine Minute.

**3.** Verfahren nach Anspruch 1 oder 2, wobei das gegebene elektrische Gerät ein Warmwasserspeicher ist, und wobei die gegebene Zeitspanne mindestens eine Nachttarifstunden-Zeitspanne umfasst, und wobei die Abschätzung der Kurve der elektrischen Leistung, die von dem Gerät verbraucht wird, auf die mindestens eine Nachttarifstunden-Zeitspanne beschränkt ist.

**4.** Verfahren nach einem der vorhergehenden Ansprüche, das außerdem einen Schritt (135) der Abschätzung der maximalen Leistung, die von dem gegebenen Gerät verbraucht wird, und einen Schritt (136) der Anwendung einer ersten Korrektur auf die geschätzte Kurve umfasst, um eine erste korrigierte Kurve zu erhalten, wobei die erste Korrektur darin besteht, die Leistung, die von dem elektrischen Gerät während der gegebenen Zeitspanne verbraucht wird, auf Werte unter der maximalen Leistung zu begrenzen.

5. Verfahren nach den Ansprüchen 3 und 4, wobei das Volumen des Warmwasserspeichers bekannt ist, und wobei die maximale verbrauchte Leistung, ausgehend von dem Volumen geschätzt wird.

6. Verfahren nach Anspruch 4, wobei eine kontinuierliche Ladungskurve, die den Stromverbrauch der Einheit der Geräte für eine Zeitspanne vor der gegebenen Zeitspanne darstellt, gespeichert wird, wobei die frühere Zeitspanne kontinuierlich ist und mindestens Nachttarifstunden-Zeitspannen und Volltarifstunden-Zeitspannen umfasst, und wobei der Schritt (135) der Abschätzung der maximalen Leistung, die von dem elektrischen Gerät verbraucht wird, Folgendes umfasst:

   - für jede frühere Nachttarifstunden-Zeitspanne, Bestimmen des Unterschieds zwischen dem Wert der Ladungskurve im ersten Augenblick oder im zweiten Augenblick der Nachttarifstunden-Zeitspanne und dem Wert der Ladungskurve in dem Augenblick, der dem ersten Augenblick direkt vorausgeht,
   - ausgehend von den bestimmten Unterschieden, Abschätzen der maximalen Leistung, die von dem elektrischen Gerät verbraucht wird.

7. Verfahren nach einem der vorhergehenden Ansprüche, wobei das Verfahren bei dem Empfang der Ladungskurve die Anwendung (132) einer Aufschlüsselung in Wavelets umfasst, um eine rauschunterdrückte Ladungskurve zu erhalten, und wobei die untere Hüllkurve ausgehend von der rauschunterdrückten Ladungskurve bestimmt wird, und die Kurve der elektrischen Leistung, die von dem gegebenen Gerät während der gegebenen Zeitspanne verbraucht wird, durch Subtraktion der unteren Hüllkurve von der rauschunterdrückten Ladungskurve geschätzt wird.

8. Verfahren nach Anspruch 7, wobei eine Variationsrate $T[P(t)]$ der Ladungskurve in einem gegebenen Augenblick t der gegebenen Zeitspanne wie folgt bestimmt wird:

$$T[P(t)]=[P(t) - P(t-1)/P(t-1)$$

   wobei $P(t)$ die von der Einheit von Geräten im gegebenen Augenblick t verbrauchte Leistung darstellt, und $P(t-1)$ die Leistung darstellt, die von der Einheit von Geräten im Augenblick t-1, der dem gegebenen Augenblick t direkt vorausgeht, verbraucht wird,
   wobei das Verfahren außerdem einen Schritt (137) der Anwendung einer zweiten Korrektur auf die geschätzte Kurve, $ECS_1$ genannt, umfasst, um eine zweite korrigierte Kurve, $ECS_2$ genannt, zu erhalten,
   wobei $t_0$ der Anfangsaugenblick einer Nachttarifstunden-Zeitspanne der gegebenen Zeitspanne ist, wobei eine Variable ECS_Grenze auf den Wert der im Augenblick $t_0$ geschätzten Kurve $ECS_1$ aktualisiert ist,
   wobei die zweite korrigierte Kurve wie folgt für alle Augenblicke t, die auf den Augenblick $t_0$ der Nachttarifstunden-Zeitspanne folgen, erhalten wird:

   - wenn $t<t_a+th_1$ und wenn $|T[P(t)]|<th_2$, dann ECS2 (t) =Max (ECS_Grenze* (1+T[P(t)] $ECS_1$(t))
   - anderenfalls,

      • wenn $t \geq t_0+th_1$ und $|T[P(t)]$ I $<th_3$, dann $ECS_2$ (t) =$ECS_1$ (t) und ECS_Grenze=$ECS_1$ (t) ;
      • anderenfalls

         * wenn $T[P(t)] <-th_4$ oder $T[P(t)]>th_2$, dann $ECS_2$ (t)=$ECS_1$ (t) und ECS_Grenze wird auf den Wert $ECS_1$(t) für die Augenblicke aktualisiert, die auf den Augenblick t in der Nachttarifstunden-Zeit-spanne folgen,
         * anderenfalls $ECS_2$(t)=$ECS_1$(t) ,

   wobei Max(A,B) den maximalen Wert zwischen A und B bezeichnet,
   wobei $th_1$ ein vorbestimmter Schwellenwert ist, der in Stunden ausgedrückt ist,
   wobei $th_2$, $th_3$ und $th_4$ vorbestimmte Schwellenwerte sind, die in Prozentsätzen ausgedrückt sind, wobei $th_3$ kleiner ist als $th_2$.

9. Verfahren nach den Ansprüchen 4 und 8, wobei die maximale von dem gegebenen Gerät verbrauchte Leistung Pmax genannt wird, wobei das Verfahren außerdem einen Schritt (137) der Anwendung einer dritten Korrektur auf die zweite korrigierte Kurve $ECS_2$ umfasst, um eine dritte korrigierte Kurve, $ECS_3$ genannt, zu erhalten, wobei die dritte korrigierte Kurve wie folgt für alle Augenblicke t vor dem Augenblick $t_0 + th_1$ erhalten wird:

wenn $ECS_2(t) < \dfrac{P\,max}{3}$, wenn $ECS_2(t-1) > \dfrac{2*P\,max}{3}$ und

wenn $ECS_2(t+1) > \dfrac{2*P\,max}{3}$,

$$\text{dann } ECS_3(t) = \frac{ECS_2(t-1) + ECS_2(t+1)}{2},$$

anderenfalls $ECS_3(t) = ECS2(t)$.

**10.** Verfahren nach Anspruch 8 oder 9, wobei das gegebene Gerät während Auslösezeitspannen funktioniert, die in einer Nachttarifstunden-Zeitspanne der gegebenen Zeitspanne enthalten sind, in der die elektrische Leistung von dem gegebenen elektrischen Gerät nur während der Auslösezeitspannen verbraucht wird, wobei die Nachttarifstunden-Zeitspanne mindestens eine erste Auslösezeitspanne und eine zweite Auslösezeitspanne umfasst, wobei das Verfahren außerdem die Anwendung (138) einer vierten Korrektur auf die zweite korrigierte Kurve $ECS_2$ umfasst, um eine vierte korrigierte Kurve, $ECS_4$ genannt, zu erhalten, wobei die vierte Korrektur Folgendes umfasst:

- Bestimmung eines Augenblicks $t_1$ zur Abgrenzung zwischen der ersten Auslösezeitspanne und der zweiten Auslösezeitspanne,
- Bestimmung einer Grenze $th_{second}$ des zweiten Auslösens, die in Prozenten ausgedrückt ist,

und die vierte korrigierte Kurve $ECS_4$ wie folgt erhalten wird:

- für $t \in [t_0; t_1]$, $ECS_4(t) = ECS_2(t)$,

- für $t \in \,]t_1; t_f]$, $ECS_4(t) = Min\left\{ \underset{t<t_1}{Max}\{ECS_2(t)\} \times th_{second}; ECS_2(t) \right\}$,

wobei Min(A;B) das Minimum zwischen A und B bezeichnet;
wobei $t_f$ ein Endaugenblick der gegebenen Zeitspanne ist.

**11.** Verfahren nach den Ansprüchen 9 und 10, wobei die vierte Korrektur auf die dritte korrigierte Kurve $ECS_3$ angewandt wird.

**12.** Verfahren nach einem der vorhergehenden Ansprüche, wobei das Verfahren außerdem das Vorhersehen (139) einer Betriebsdauer des gegebenen elektrischen Geräts während einer Zeitspanne nach der gegebenen Zeitspanne in Abhängigkeit von der Kurve der elektrischen Leistung, die von dem elektrischen Gerät während der gegebenen Zeitspanne verbraucht wird, umfasst.

**13.** Rechnerprogrammprodukt, das Programmcode-Anweisungen, die auf einem Träger aufgezeichnet sind, der durch einen Rechner lesbar ist, für die Ausführung der Schritte des Verfahrens nach einem der Ansprüche 1 bis 12 umfasst.

**14.** Vorrichtung zur Abschätzung des Stromverbrauchs eines gegebenen elektrischen Geräts aus einer Einheit elektrischer Geräte, die die folgenden Einheiten umfasst:

- eine Einheit (12) zum Empfang einer Ladungskurve, die den Stromverbrauch der Einheit elektrischer Geräte in gegebenen Augenblicken während einer gegebenen Zeitspanne darstellt,
- eine Einheit (14) zur Bestimmung einer unteren Hüllkurve der Ladungskurve,
- eine Einheit (15) zur Abschätzung einer Kurve der elektrischen Leistung, die von dem elektrischen Gerät während der gegebenen Zeitspanne verbraucht wird, durch Subtraktion der bestimmten unteren Hüllkurve von der Ladungskurve,

wobei die Ladungskurve außerdem für Zeitspannen vor und nach der gegebenen Zeitspanne empfangen wird, wobei die Vorrichtung **dadurch gekennzeichnet ist, dass** die Einheit zur Bestimmung der unteren Hüllkurve der Ladungskurve außerdem konfiguriert ist, um für jeden Augenblick der gegebenen Zeitspanne:

- den Mindestwert unter den Werten der jeweiligen Ladungskurve für die n Augenblicke, die dem gegebenen Augenblick vorausgehen, für den gegebenen Augenblick und für die n Augenblicke, die auf den gegebenen Augenblick folgen, zu bestimmen, wobei n eine Ganzzahl größer oder gleich eins ist,
- dem Augenblick den bestimmten Mindestwert zuzuweisen,

wobei die Mindestwerte verbunden werden, um die unter Hüllkurve der Ladungskurve zu erhalten.

**Claims**

1. A method for estimating the electric energy consumption of a given electrical device among a set of electrical devices, comprising the following steps carried out by an estimation device (11):

   receiving (131) a load curve representative of the electric energy consumption of said set of electrical devices at given moments, over a given period;
   determining (133) a lower envelope of said load curve;
   estimating (134) an electric energy consumption curve for the given electrical device over the given period, by subtracting the determined lower envelope from said load curve;

   wherein the load curve is also received for periods before and after the given period, the method being **characterized in that** the step of determining (133) the lower envelope of the load curve comprises the following steps, for each moment in the given period:

   determining the minimum value among the respective values of the load curve for the n moments before the given moment, for the given moment, and for the n moments after the given moment, where n is integer greater than or equal to one;
   assigning the determined minimum value to said moment,

   said minimum values being connected to obtain the lower envelope of the load curve.

2. The method according to claim 1, wherein the given moments are spaced apart at regular intervals, said regular intervals being greater than one minute.

3. The method according to claim 1 or 2, wherein the given electrical device is a hot water tank and wherein the given period comprises at least one period of off-peak hours, and wherein the estimation of the electric energy consumption curve of the electrical device is restricted to said at least one period of off-peak hours.

4. The method according to one of the preceding claims, further comprising a step of estimating (135) the maximum power consumed by said given device, and a step of applying (136) a first correction to said estimated curve in order to obtain a first corrected curve, said first correction consisting of limiting the power consumed by said electrical device to values less than said maximum power, over the given period.

5. The method according to claim 3 or 4, wherein the volume of the hot water tank is known, and wherein the maximum power consumed is estimated from said volume.

6. The method according to claim 4, wherein a continuous load curve representing the electric energy consumption of the set of devices for a period prior to said given period is stored, said prior period being continuous and comprising at least some periods of off-peak hours and periods of peak hours, and wherein the step of estimating (135) the maximum power consumed by said electrical device comprises:

   determining, for each prior period of off-peak hours, the difference between the value of the load curve at moment one or at moment two in said period of off-peak hours and the value of the load curve at the moment immediately preceding said moment one;
   estimating, from the determined differences, the maximum power consumed by said electrical device.

**7.** The method according to claim 1, wherein, upon receipt of the load curve, the method comprises the application (132) of a wavelet decomposition in order to obtain a denoised load curve, and wherein the lower envelope is determined from the denoised load curve, and the electric energy consumption curve of the given device is estimated by subtracting the lower envelope from the denoised load curve, over the given period.

**8.** The method according to claim 7, wherein a rate of change T[P(t)] of the load curve at a given moment t of the given period is determined as follows:

$$T[P(t)] = [P(t) - P(t-1)/P(t-1)$$

where P(t) represents the power consumed by the set of devices at given moment t and where P(t-1) represents the power consumed by the set of devices at moment t-1 directly preceding given moment t;

said method further comprising a step of applying (137) a second correction to said estimated curve denoted $ECS_1$, in order to obtain a second corrected curve denoted $ECS_2$,

where $t_0$ is the starting moment of a period of off-peak hours of the given period, a variable ECS_plateau being initialized to the value of the estimated curve $ECS_1$ at moment $t_0$,

said second corrected curve being obtained in the following manner, for all moments t following moment $t_0$ of said period of off-peak hours:

if $t < t_0 + th_1$ and if $|T[P(t)]| < th_2$, then $ECS_2(t) = Max(ECS\_plateau*(1+T[P(t)]$ ; $ECS_1(t))$ else
if $t > t_0 + th_1$ and $|T[P(t)]| < th_3$, then $ECS_2(t) = ECS_1(t)$ and ECS_plateau$=ECS_1(t)$;

else
if $T[P(t)] < -th_4$ or $T[P(t)] > th_2$ then $ECS_2(t) = ECS_1(t)$ and ECS_plateau is set to the value of $ECS_1(t)$ for the moments subsequent to moment t in the period of off-peak hours;
else $ECS_2(t) = ECS_1(t)$;

where Max(A,B) indicates the maximum value among A and B;
where $th_1$ is a predetermined threshold expressed in hours,
where $th_2$, $th_3$, and $th_4$ are predetermined thresholds expressed in percentages, $th_3$ being less than $th_2$.

**9.** The method according to claim 4 and 8, wherein the maximum power consumed by said given device is denoted Pmax, wherein the method further comprises a step of applying (137) a third correction to the second corrected curve $ECS_2$, in order to obtain a third corrected curve denoted $ECS_3$,
said third corrected curve being obtained as follows, for all moments t preceding moment $t_0$ +th:

if $ECS_2(t) < \dfrac{Pmax}{3}$, if $ECS_2(t-1) > \dfrac{2*Pmax}{3}$, and if $ECS_2(t+1) > \dfrac{2*Pmax}{3}$

then $ECS_3(t) = \dfrac{ECS_2(t-1) + ECS_2(t+1)}{2}$ ;

else $ECS_3(t) = ECS_2(t)$.

**10.** The method according to claim 8 or 9, wherein said given device operates in activation periods contained within a period of off-peak hours of the given period, wherein electric power is consumed by the given electrical device only during the activation periods, the period of off-peak hours comprising at least a first activation period and a second activation period,
wherein the method further comprises the application (138) of a fourth correction to the second corrected curve $ECS_2$ in order to obtain a fourth corrected curve denoted $ECS_4$, said fourth correction comprising:

determining a moment $t_1$ of demarcation between the first activation period and the second activation period;
determining a second activation threshold $th_{second}$, expressed in percentages;

and the fourth corrected curve $ECS_4$ being obtained as follows:

for $t \in [t_0;t_1]$, $ECS_4(t) = ECS_2(t)$;

$$\text{for } t \in \left]t_1; t_f\right], \; ECS_4(t) = Min\left\{\underset{t<t_1}{Max}\left\{ECS_2(t)\right\} \times th_{second}; ECS_2(t)\right\}$$

where Min(A;B) indicates the minimum among A and B;
$t_f$ being an ending moment of the given period.

11. The method according to claims 9 and 10, wherein the fourth correction is applied to the third corrected curve $ECS_3$.

12. The method according to one of the preceding claims, further comprising the prediction (139) of the length of operation of the given electrical device for a period subsequent to the given period, based on the electric energy consumption curve of the electrical device over the given period.

13. A non-transitory computer readable storage medium, with a program stored thereon, wherein the program comprises program instruction code for executing the steps of the method according anyone of claims 1 to 12.

14. A device for estimating the electric energy consumption of a given electrical device among a set of electrical devices, comprising the following units:

a unit for receiving (12) a load curve representative of the electric energy consumption of said set of electrical devices at given moments, over a given period;
a unit for determining (14) a lower envelope of said load curve;
a unit for estimating (15) an electric energy consumption curve of the electrical device over the given period, by subtracting the determined lower envelope from said load curve;

wherein the load curve is also received for periods before and after the given period, the device being **characterized in that** the unit for determining the lower envelope of the load curve if further configured for, for each moment in the given period:

determining the minimum value among the respective values of the load curve for the n moments before the given moment, for the given moment, and for the n moments after the given moment, where n is integer greater than or equal to one;
assigning the determined minimum value to said moment,

said minimum values being connected to obtain the lower envelope of the load curve.

**FIG. 1**

FIG. 2

EP 2 913 786 B1

**FIG. 3**

FIG. 4

FIG. 5

FIG. 6

FIG. 7

FIG. 8

FIG. 9

**FIG. 10**

FIG. 11

**FIG. 12**

REC — 131

WAV — 132

DET1 — 133

EST2 — 134

135 — EST1

EST3 — 136

EST4 — 137

EST5 — 138

J+1 — 139

OPT — 140

**FIG. 13**

# RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **MABROUKA EL GUEDRI.** *Caractérisation aveugle de la courbe de charge électrique : Détection, classification et estimation des usages dans les secteurs résidentiel et tertiaire,* 09 Novembre 2009
- Transformée en ondelettes. **PETR KLAPETEK ; DAVID NECAS ; CHRISTOPHER ANDRESON.** Guide utilisateur Gwyddion. 14 Janvier 2014
- **L.DONOHO ; M.JOHNSTONE.** Adapting to unknwown smoothness via Wevelet shrinkage. *Journal of the American Statistical Association,* 1995, vol. 90 (432), 1200-1224